# FASCICULE DE BREVET EUROPEEN

(11) **EP 4 198 839 B1**
(45) Date de publication et mention de la délivrance du brevet: **18.11.2026**
(21) Numéro de dépôt: 22214658.1
(22) Date de dépôt: 19.12.2022
(51) Int. Cl.: G06N 10/40

(54) **PROCÉDÉS DE DÉTERMINATION DU FACTEUR DE CONVERSION ENTRE LA TENSION APPLIQUÉE À UN SYSTÈME ET UN PARAMÈTRE DUDIT SYSTÈME, DE LA PÉRIODE D'OSCILLATION ENTRE DEUX ÉTATS DE SPIN ET DE L'INTERACTION D'ÉCHANGE ENTRE DEUX PARTICULES CHARGÉES ET SYSTÈME ASSOCIÉ**
VERFAHREN ZUR BESTIMMUNG DES WANDLUNGSFAKTORS ZWISCHEN EINER SYSTEMSPANNUNG UND EINEM PARAMETER DAVON, DER OSZILLATIONSPERIODE ZWISCHEN ZWEI SPINNZUSTÄNDEN UND DER INTERAKTION ZWISCHEN ZWEI GELADENEN TEILCHEN
METHODS FOR DETERMINING SYSTEM VOLTAGE CONVERSION FACTOR, SPIN STATE OSCILLATION PERIOD, AND EXCHANGE INTERACTION BETWEEN TWO CHARGED PARTICLES AND SYSTEM THEREOF

(30) Priorité: 20.12.2021 FR 2114015
(43) Date de publication de la demande: 21.06.2023
(73) Titulaire: Commissariat à l'Energie Atomique et aux Energies Alternatives, 75015 Paris (FR); Centre National de la Recherche Scientifique, 75016 Paris (FR)
(72) Inventeur: MORTEMOUSQUE, Pierre-André, 38054 GRENOBLE CEDEX 09 (FR); JADOT, Baptiste, 38054 GRENOBLE CEDEX 09 (FR); MEUNIER, Tristan, 38000 GRENOBLE (FR); URDAMPILLETA, Matias, 38000 GRENOBLE (FR)
(74) Mandataire: Cabinet Camus Lebkiri

(56) Documents cités:
- US-B1- 10 482 388
- BAPTISTE JADOT ET AL: "Distant spin entanglement via fast and coherent electron shuttling", ARXIV.ORG, CORNELL UNIVERSITY LIBRARY, 201 OLIN LIBRARY CORNELL UNIVERSITY ITHACA, NY 14853, 6 April 2020 (2020-04-06), XP081893699, DOI: 10.1038/S41565-021-00846-Y
- PIERRE-ANDRE MORTEMOUSQUE ET AL: "Coherent control of individual electron spins in a two dimensional array of quantum dots", ARXIV.ORG, CORNELL UNIVERSITY LIBRARY, 201 OLIN LIBRARY CORNELL UNIVERSITY ITHACA, NY 14853, 19 August 2018 (2018-08-19), XP081258368

## Description

### DOMAINE TECHNIQUE DE L'INVENTION

Le domaine technique de l'invention est l'informatique quantique.

La présente invention concerne un procédé de détermination d'un facteur de conversion entre la tension appliquée à un système et un paramètre de ce système. Elle concerne également la détermination de la période d'oscillation entre deux états de spin et l'interaction d'échange entre deux particules chargées.

### ARRIERE-PLAN TECHNOLOGIQUE DE L'INVENTION

Lorsque l'on souhaite réaliser des opérations quantiques à l'aide d'un dispositif quantique comprenant une matrice de qubits comprenant une pluralité de boites quantiques, il est connu de mettre en œuvre une procédure de calibration de sorte à identifier les différents régimes de fonctionnement du dispositif quantique et à déterminer les points de fonctionnements les plus adaptées en fonction des opérations envisagées, mais également les points de fonctionnement permettant d'obtenir les mesures les plus exploitable (faible bruit, fort contraste, etc.)

Une telle procédure est cependant très fastidieuse et nécessite beaucoup de temps. De plus, il est nécessaire de bien connaitre la physique sous-jacente au dispositif quantique utilisé afin de pouvoir effectuer une telle procédure.

Afin de pallier une partie au moins de ces inconvénients, un premier document (Botzem, T. et al ; « Tuning Methods for Semiconductor Spin Qubits » ; Phys. Rev. Applied, American Physical Society, 2018, 10, 054026) propose une méthode d'automatisation partielle de cette procédure. Plus particulièrement, la méthode proposée dans ce document permet de déterminer les points de fonctionnement relatifs au chargement de deux particules chargées dans un couple de boites quantiques. Il permet également de déterminer les points de fonctionnement associés à une propriété caractéristique de l'état de spin de deux particules chargées : le croisement ST+. Un deuxième document (EP3214038) propose également une automatisation partielle de cette procédure. Plus particulièrement, comme le document précédent, la méthode proposée permet de déterminer les points de fonctionnement relatifs au chargement de deux particules chargées dans un couple de boites quantiques.

Cependant, les méthodes proposées dans ces deux documents ne permettent pas d'effectuer une telle calibration sans une connaissance préalable de certains paramètres de fonctionnement du système. Autrement dit, ces méthodes ne peuvent pas être mises en œuvre sur un système inconnu a priori. C'est en particulier vrai pour les paramètres de fonctionnement relatifs à l'initialisation des états de spin des particules chargées, mais également la lecture de ces états de spin. Cette limitation concerne également les points de fonctionnement optimaux associés aux différentes portes quantiques pour lesquels les méthodes de l'état de la technique nécessitent une procédure de lecture afin de mettre en œuvre une boucle de contre-réaction.

En particulier, cette calibration est rendue difficile par le risque de voir le système changer d'état de charge lors de la phase de calibration. Notamment, cette instabilité de l'état de charge ne permet pas de caractériser convenablement le facteur de conversion entre les tensions appliquées au système et au moins un paramètre dudit système, ou bien encore la période d'oscillation entre deux états de spin ou l'interaction d'échange entre deux particules chargées, des informations pourtant essentielles à une bonne mise en œuvre des portes quantiques.

Aussi, il existe un besoin pour une méthode permettant, en limitant les risques de changement de l'état de charge du système lors de la calibration et notamment la phase de lecture de l'état de charge, de déterminer un facteur de conversion entre la ou les tensions appliquées au système et au moins un paramètre de ce système. Il existe également un besoin d'une méthode permettant de détermine l'interaction d'échange entre deux particules chargées ou bien encore la période d'oscillation entre deux états de spin.

BAPTISTE JADOT ET AL: "Distant spin entanglement via fast and coherent electron shuttling",ARXIV.ORG, CORNELL UNIVERSITY LIBRARY, 201 OLIN LIBRARY CORNELL UNIVERSITY ITHACA, NY 14853, 6 avril 2020 (2020-04-06), DOI: 10.1038/ S41565-021-00846-Y décrit une technique de calibration pour une intrication quantique à distance entre boîtes quantiques.

### RESUME DE L'INVENTION

L'invention offre une solution aux problèmes évoqués précédemment, en permettant, à l'aide d'un ou plusieurs points de fonctionnement pour lesquels la stabilité de l'état de charge est garanti pour une durée de référence donnée, de déterminer le facteur de conversion entre les tensions appliquées au système et deux paramètres de ce système. Elle offre également, à l'aide de tels points de fonctionnement, une méthode permettant de déterminer l'interaction d'échange entre deux particules chargées ou bien encore la période d'oscillation entre deux états de spin.

L'invention est définie par les revendication(s) indépendante(s). Des modes de réalisation avantageux sont définis par les revendication(s) dépendante(s).

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.
La [Fig. 1] montre une représentation schématique d'un système.
La [Fig. 2] montre une représentation schématique du couplage entre le couple de boites quantiques et un réservoir de particules chargées
La [Fig. 3] montre une représentation schématique du couplage entre les deux boites quantiques d'un couple de boites quantiques.
La [Fig. 4] montre un ordinogramme d'un premier procédé.
La [Fig. 5] montre une représentation schématique d'un diagramme de stabilité d'un couple de boites quantiques.
La [Fig. 6] montre une représentation schématique d'un diagramme de stabilité des deux boites quantiques du couple de boites quantiques.
La [Fig. 7] montre une représentation schématique d'un diagramme de stabilité d'un couple de boites quantiques faisant apparaitre la zone de régime partiellement isolé et la région associée au chargement de deux particules chargées.
La [Fig. 8] montre une représentation schématique d'un diagramme de stabilité des deux boites quantiques du couple de boites quantiques faisant apparaitre la région associée au régime totalement isolé.
Les [Fig. 9A] à [Fig. 9G] montrent une représentation schématique d'une méthode permettant de déterminer les points de fonctionnement associés au régime totalement isolé.
La [Fig. 10] montre une représentation schématique de la position d'un point de chargement de deux particules chargées dans un diagramme de stabilité du couple de boites quantiques.
La [Fig. 11] montre une représentation schématique de la position d'un point de chargement d'une boite quantique dans un diagramme de stabilité des boites quantique du couple de boites quantiques.
Les [Fig. 12] à [Fig. 17] montrent une représentation schématique des modifications de point de fonctionnement dans le premier procédé.
La [Fig. 18] montre une représentation schématique de l'évolution de la probabilité de mesurer un premier état de charge en fonction d'un temps d'attente.
Les [Fig. 19] et [Fig. 20] montre une représentation schématique d'une réinitialisation du système au point de fonctionnement de chargement.
La [Fig. 21] montre une représentation schématique des états de spin de deux particules chargées dans un couple de boites quantiques.
La [Fig. 22] montre un ordinogramme d'un deuxième procédé.
La [Fig. 23] montre une représentation schématique du chargement dans le deuxième procédé.
La [Fig. 24] montre un ordinogramme d'un troisième procédé.
La [Fig. 25A] montre une courbe représentant le signal mesuré par le moyen de mesure de l'état de charge pour deux états de charge différents.
La [Fig. 25B] montre une courbe représentant la différence obtenue dans le signal mesuré par le moyen de mesure de l'état de charge pour deux états de charge différents.
La [Fig. 26] montre un ordinogramme d'un quatrième procédé.
Les [Fig. 27] à [Fig. 30] montrent une représentation schématique des étapes du quatrième procédé.
La [Fig. 31] montre un ordinogramme d'un cinquième procédé.
La [Fig. 32] montre un ordinogramme d'un sixième procédé.
La [Fig. 33] montre une représentation schématique des étapes du sixième procédé.
La [Fig. 34] montre une mesure de l'évolution de la probabilité de mesuré un état de spin singulet en fonction d'une tension de grille.
La [Fig. 35] montre un ordinogramme d'un septième procédé.
Les [Fig. 36] à [Fig. 40] montrent une représentation schématique des étapes du septième procédé.
La [Fig. 41] montre une cartographie de probabilité de mesurer un état singulet obtenue à l'aide du septième procédé .
La [Fig. 42] montre un ordinogramme d'un huitième procédé.
Les [Fig. 43] à [Fig. 46] montrent une représentation schématique des étapes du huitième procédé.
La [Fig. 47] montre une cartographie de probabilité de mesurer un état singulet obtenue à l'aide du huitième procédé.
La [Fig. 48] montre une mesure de l'évolution de l'excitation en fonction de la fréquence appliquée.

### DESCRIPTION DETAILLEE

Les figures sont présentées à titre indicatif et nullement limitatif de l'invention.

Sauf précision contraire, un même élément apparaissant sur des figures différentes présente une référence unique.

On notera que les figure illustrent toutes le cas où les particules chargées sont des électrons. Cependant, ce choix influence principalement l'orientation des axes sans modifier les enseignements fournis par ces illustrations pour un cas où les particules chargées sont des trous par exemple. De même, tous les exemples donnés sont relatifs à un facteur g (ou g-factor en anglais) négatif pour lesquels on s'intéresse au croisement S-T+. Cependant, dans le cas d'un facteur g positif, le terme « croisement S-T+ » est à remplacer par « croisement S-T- », « T+ » est à remplacer par « T- » et « T- » est à remplacer par « T+ ».

Dans la présente description, il est fait référence à des modifications adiabatiques et non adiabatiques.

Lorsque cette notion est employée en faisant référence à deux états de spin (par exemple, croisement évité ST+ ou ST0), alors elle fait référence aux transitions Landau-Zenner bien connues de la personne du domaine qui peuvent se produire au passage de l'anti-croissement entre les deux états considérés. Dans ce contexte, on entend par adiabatique que la probabilité de rester dans l'état fondamental est supérieure ou égale à 0.99 (99%), de préférence supérieure ou égale à 0.999 (99.9%), voire supérieure ou égale à 0.9999 (99.99%). De manière analogue, on entend par non adiabatique que la probabilité de transiter vers l'état excité est supérieure ou égale à 0.99 (99%), de préférence supérieure ou égale à 0.999 (99.9%), voire supérieure ou égale à 0.9999 (99.99%).

Lorsque cette notion est employée en faisant référence au couplage tunnel entre deux systèmes alors, alors elle fait référence à la transition d'une particule chargée d'un système à l'autre. Plus particulièrement, dans le cas du transfert d'une particule chargées dans une boite quantique issue d'un réservoir de particules chargée, si, pour la particules chargées, deux états sont possibles dans la boite quantique (par exemple singlet et triplet), ces deux états étant séparés en énergie, si le couplage tunnel est grand devant le temps de montée du pulse permettant le transfert (c'est-à-dire la modification du point de fonctionnement), alors seul l'état fondamental sera créé, si le couplage tunnel est petit devant ce temps de monté alors les deux état peuvent être créé. Ainsi, par analogie avec la transition Landau-Zenner, une modification du point de fonctionnement relativement à un couplage tunnel est dite adiabatique lorsque, lors de cette modification, la probabilité de créé un état fondamental est supérieure ou égale à 0.99 (99%), de préférence supérieure à 0.999 (99.9%), voire supérieure ou égale à 0.9999 (99.99%). De manière analogue, une modification du point de fonctionnement relativement à un couplage tunnel est dite non adiabatique lorsque, lors de cette modification, la probabilité de créé un état fondamental est sensiblement (c'est-à-dire à plus ou moins 10%, de préférence plus ou moins 5%, voire plus ou moins 1%) identique à la probabilité de créé un état excité.

Bien entendu, ces notions sont connues de la personne du métier et ne sont rappelées qu'à titre informatif. De la même manière, lorsque la notion de modification ou chargement adiabatique ou non adiabatique est évoquée, la description précisera en général à quelles grandeurs du système il est fait référence. Il est clair qu'une personne du métier saura identifier les grandeurs du système pertinentes et ces précisions ne sont donc apportées que dans un but didactique.

### Introduction

Afin de permettre une compréhension de l'invention plus aisée, il peut être utile d'introduire une série de définitions qui seront utilisées dans la suite de cette description. Mais pour cela, il est commode de présenter au préalable le système SYS auquel s'appliquent ces définitions.

### Système selon l'invention

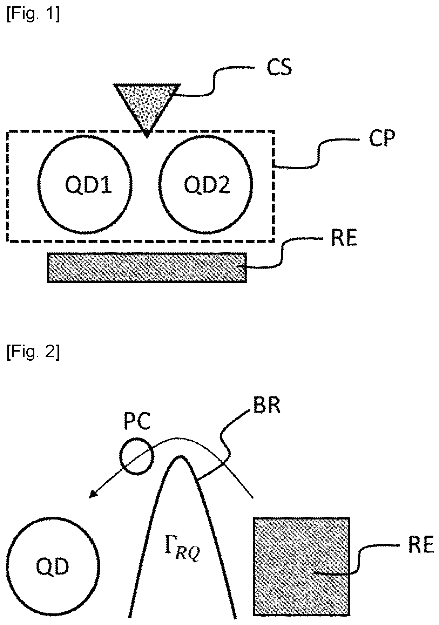

Comme illustré à la [Fig. 1], le système SYS comprend au moins un réservoir RE de particules chargées PC, un couple CP de boites quantiques QD contenant zéro, une ou plusieurs particules chargées PC, les particules chargées PC étant porteuses d'un spin. De plus, le régime de fonctionnement du système SYS peut être modulé à l'aide d'une pluralité de tensions de grille. Par exemple, le couplage tunnel entre le couple CP de boites quantiques QD et le ou les réservoir peut être modulé à l'aide d'une première tension V1 de grille et d'une deuxième tension V2 de grille, la valeur de ces deux tensions V1,V2 définissant un point de fonctionnement Pi du système SYS. De la même manière, le couplage tunnel entre les deux boites quantiques QD du couple CP de boites quantiques QD peut être modulé à l'aide d'une troisième tension V1' de grille et d'une quatrième tension V2' de grille. Chaque jeu de valeurs de ces différentes tensions est associé à un point de fonctionnement du système SYS. Autrement dit, un point de fonctionnement définit le jeu de valeurs des tensions appliquées aux grilles du système SYS. Le point de fonctionnement du système peut donc être modifié en modifiant une ou plusieurs des tensions appliquées aux grilles du système SYS.

Compte tenu de l'influence qu'exercent les grilles les unes sur les autres (on parle de « cross-talk » en anglais), une combinaison de tensions de grille est en général nécessaire afin de moduler les couplages tunnels évoqués plus haut. Cependant, à des fins de simplification et parce que la prise en compte de ces « cross-talk » relève de la pratique quotidienne de la personne du domaine, la situation simplifiée évoquée précédemment sera en général utilisée dans la suite de la description.

Le système SYS comprend également un moyen de mesure CS de l'état de charge du couple CP de boites quantiques QD générant un signal fonction de l'état de charge du couple CP de boites quantiques QD. Ce moyen de mesure CS peut par exemple comprendre un ou plusieurs électromètres.

### Régime d'isolation partielle

On entend par régime d'isolation partielle tous les points de fonctionnement pour lesquels le couple CP de boites quantiques QD est isolé du ou des réservoirs RE de particules chargées PC. Ainsi, dans le régime d'isolation partielle, le nombre de particules chargées PC au sein du couple CP de boites quantiques QD est fixe, mais le nombre de particules chargées PC au sein d'une boite quantique QD peut varier dans les limites fixées par le nombre de particule chargées PC dans le couple CP de boites quantiques QD. Plus généralement, on parlera de régime d'isolation partielle, d'isolement partiel, d'isolation partielle ou bien encore de régime partiellement isolé.

Afin de préciser ce terme d'isolation partielle (ou de régime d'isolation partielle), le lecteur pourra se référer à la [Fig. 2] sur laquelle est représentée une boite quantique QD séparée d'un réservoir RE de particules chargées PC par une barrière de potentiel BR caractérisée au moyen d'un paramètre Γ_{RQ} connu du domaine sous le terme anglais de *tunneling rate.* La boite quantique QD est considérée isolée du réservoir RE de particules chargées PC pour une opération donnée si la durée caractéristique associée à ladite opération *τₒₚ* est telle que :
[Math. 1] $\frac{1}{{τ}_{op}} ≫ {Γ}_{RQ}$

Par exemple,
[Math. 2] $\frac{1}{{τ}_{op}} > {α}_{RI} \times {Γ}_{RQ}$
où *α_{RI}* est un coefficient permettant de définir la tolérance à l'erreur. Dans un exemple de réalisation, *α_{RI}* = 100. Autrement dit, la définition du régime partiellement isolé est relative à une durée de référence. La manière de vérifiée qu'une telle condition est remplie sera détaillée dans la suite.

### Régime d'isolation totale

On entend par régime d'isolation totale tous les points de fonctionnement pour lesquels les boites quantiques QD du couple CP de boites quantiques QD sont isolées l'une de l'autre et sont isolées du ou des réservoirs RE de particules chargées PC lorsqu'un tel réservoir RE est présent. Ainsi, dans le régime d'isolation totale, le nombre de particules chargées PC au sein de chaque boite quantique QD du couple CP de boites quantiques QD est fixe. Plus généralement, on parlera de régime d'isolation totale, d'isolement total, d'isolation totale ou bien encore de régime totalement isolé. Il peut être utile de noter que, le régime d'isolation totale suppose le régime d'isolation partiel : en effet, le nombre de particules chargées PC dans chaque boite quantique QD et donc au niveau du couple CP de boites quantiques QD est fixé.

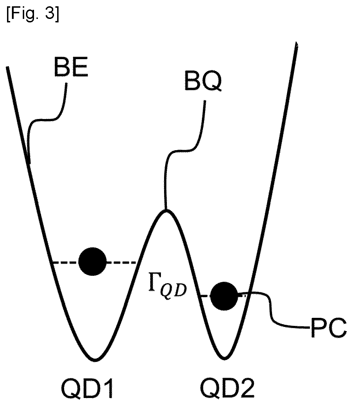

Afin de préciser ce terme d'isolation totale (ou de régime d'isolation totale), le lecteur pourra se référer à la [Fig. 3] sur laquelle sont représentées les deux boites quantiques QD1,QD2 du couple CP de boites quantiques QD séparées l'une de l'autre par une barrière de potentiel BQ caractérisée au moyen d'un paramètre Γ_{QD} connu du domaine sous le terme anglais de *tunneling rate.* Les deux boites quantiques QD1,QD2 sont considérées comme étant dans un régime totalement isolé pour une opération donnée si la durée caractéristique associé à ladite opération *τₒₚ* est tel que :
[Math. 3] $\frac{1}{{τ}_{op}} ≫ {Γ}_{QD}$

Par exemple,
[Math. 4] $\frac{1}{{τ}_{op}} > {α}_{RI} \times {Γ}_{QD}$

Où, comme précédemment, *α_{RI}* est un coefficient permettant de définir la tolérance à l'erreur. Dans un exemple de réalisation, *α_{RI}* = 100. Autrement dit, la définition du régime totallement isolé est relative à une durée de référence. La manière de vérifiée qu'une telle condition est remplie sera détaillée dans la suite.

### Intérêt de ces deux régimes

L'intérêt de ces deux régimes de fonctionnement dans la mise en œuvre des dispositifs quantiques tels que le système SYS est à mettre au crédit des inventeurs.

### Généralisation

Il est possible d'examiner les deux régimes d'isolations précédents de manière plus générale, en considérant qu'il s'agit d'isoler un premier sous-système d'un deuxième sous-système. Dans le cas du régime partiellement isolé, le premier sous-système est le couple CP de boites quantiques QD, ou une boite quantique QD1 du couple CP de boites quantiques QD et le deuxième sous-système est le réservoir RE de particules chargées PC. Dans le cas du régime totalement isolé, le premier système est la première boite quantiques QD1 et le deuxième système est la deuxième boite quantique QD2 (ou vice-versa, la qualification de première ou deuxième boite quantique n'étant qu'une convention de notation). Bien sûr, chacun de ces régimes conserve tout de même des spécificités qui seront précisées dans la suite.

### Procédé de détermination d'un point de fonctionnement en régime isolé

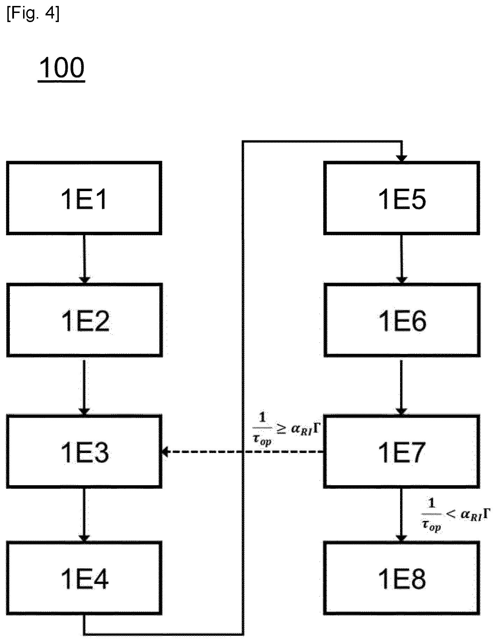

Un premier aspect illustré à la [Fig. 4] concerne un procédé 100 de détermination d'un point de fonctionnement isolé associé à un régime isolé d'un système SYS comprenant un premier sous-système CP,QD1 et un deuxième sous-système RE,QD2, ledit point de fonctionnement isolé pour lequel un passage d'une particule chargée (PC) du premier sous-système (CP,QD1) vers le deuxième sous-système (RE,QD2) et vice-versa est interdit pour une durée de référence (c'est-à-dire la durée pendant laquelle le système peut être considéré comme étant dans un régime isolé), le premier sous-système CP,QD1 et le deuxième sous-système RE,QD2 contenant zéro, une ou plusieurs particules chargées PC, un couplage tunnel existant entre le premier sous-système CP,QD1 et le deuxième sous-système RE,QD2, ledit couplage tunnel permettant l'échange d'une ou plusieurs particules chargées PC entre le premier sous-système CP,QD1 et le deuxième sous-système RE,QD2.

Autrement dit, le procédé 100 permet de déterminer un point de fonctionnement du système SYS, dit point de fonctionnement isolé, pour lequel le premier sous-système CP,QD1 est isolé du deuxième sous-système RE,QD2, c'est-à-dire un point de fonctionnement pour lequel, pour la durée de référence, une particule chargée PC ne peut pas passer du premier sous-système PC,QD1 au deuxième sous-système RE,QD2 (et vice-versa) même lorsqu'une telle transition est possible énergétiquement.

Comme déjà mentionné, le premier sous-système CP,QD1 et le deuxième sous-système RE,QD2 sont séparés l'un de l'autre par une barrière de potentiel et le couplage tunnel entre ces deux sous-systèmes peut être modulé au moyen d'une pluralité de tensions de grille, ce couplage étant par ailleurs caractérisé par un taux tunnel noté Γ. Aussi, le couplage tunnel est fonction du point de fonctionnement du système SYS lui-même déterminé par la valeur prise par chaque tension de grille de la pluralité de tensions de grille. En outre, il est possible de modifier le point Pi de fonctionnement du système SYS, et donc le couplage tunnel entre les deux sous-systèmes, en modifiant une ou plusieurs de ces tensions de grille.

Selon les définitions données en introduction, lorsque le premier sous-système est le couple CP de boites quantiques QD ou une boite quantique QD1 du couple CP de boites quantiques QD et le deuxième sous-système est le réservoir RE de particules chargées PC, alors le régime isolé évoqué précédemment correspond au régime partiellement isolé. Lorsque le premier sous-système est une boite quantique QD1 du couple CP de boites quantiques QD les échanges de particules chargées PC n'ont lieu qu'entre le réservoir RE et la boite quantiques QD1 considéré du couple CP de boites quantiques QD.

De même, lorsque le premier sous-système est la première boite quantique QD1 du couple CP de boites quantiques QD et le deuxième sous-système est la deuxième boite quantique QD2 du couple CP de boites quantiques QD, alors le régime isolé évoqué précédemment correspond au régime totalement isolé.

### Détermination d'un diagramme de stabilité du système

Le procédé 100 comprend une première étape 1E1 de détermination d'un diagramme de stabilité du système SYS de sorte à déterminer une pluralité d'états de charge pris par le premier sous-système CP,QD1 en fonction du point de fonctionnement considérée. Le concept de diagramme de stabilité est bien connu de la personne du domaine et ne sera donc pas détaillé ici. Seuls de brefs rappels seront faits pour chaque régime (partiellement ou totalement isolé).

Lorsque le régime isolé correspond au régime partiellement isolé

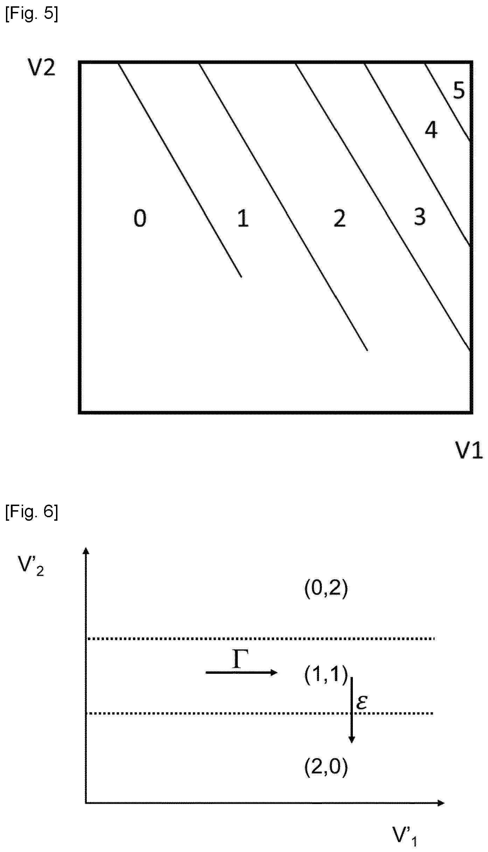

L'isolation considérée est une isolation partielle. Dans ce régime, le diagramme de stabilité du système SYS est une représentation de l'état de charge du couple CP de boites quantiques QD lorsque le premier sous-système CP,QD1 est le couple CP de boites quantiques QD ou d'une boite quantique QD1 lorsque le premier sous-système CP,QD1 est une boite quantique QD1 du couple CP de boites quantiques QD. Dans la suite, à des fins d'illustration, le premier sous-système est le couple CP de boites quantiques QD. Dans ce cas, on ne distingue pas, dans le diagramme de stabilité, la répartition de la ou des particules chargées PC au sein du couple CP de boites quantiques QD (il en sera autrement dans le cas d'un diagramme de stabilité lorsque le régime isolé correspond au régime totalement isolé). Un tel diagramme de stabilité est présenté à la [Fig. 5].

Sur cette [Fig. 5], le diagramme de stabilité représente l'état de charge du couple CP de boites quantiques QD en fonction d'une première tension V1 et d'une deuxième tension V2. De manière simplifiée, la première tension V1 permet de contrôler principalement le potentiel électrostatique au sein du couple CP de boites quantiques QD, tandis que la deuxième tension V2 permet de contrôler principalement la barrière de potentiel séparant le ou les réservoirs RE de particules chargées PC du couple CP de boites quantiques QD. En d'autres termes, la deuxième tension V2 permet de contrôler le paramètre Γ*_{RQ}* introduit précédemment et relatif au couplage tunnel entre le réservoir RE et le couple CP de boites quantiques QD. Comme mentionné en introduction, la situation est en général plus compliquée du fait des « cross-talk » entre les grilles qui se manifestent sur la [Fig. 5] par la présence de lignes obliques noires. Ces lignes obliques noires matérialisent les changements d'état de charge du couple CP de boites quantiques QD. Les états de charges sont identifiés par des chiffres indiquant le nombre de particules chargées PC dans le couple CP de boites quantiques QD. L'interruption des lignes dans la partie basse du diagramme de stabilité traduit l'isolement du couple CP de boites quantiques QD vis-à-vis du ou des réservoirs RE : les particules chargées PC ne peuvent plus être échangées et l'état de charge du couple PC de boites quantiques QD est donc fixé dans cette région du diagramme de stabilité (d'où l'absence de lignes obliques noires matérialisant les changements d'état de charge).

Ce régime correspond donc au régime d'isolement partiel : le couple de boites quantiques QD est isolées du ou des réservoirs RE de particules chargées PC, mais ne sont pas forcément isolées entre elles. Pour plus de détails, le lecteur pourra se référer à l'article Bertrand et al, Quantum Manipulation of Two-Electron Spin States in Isolated Double Quantum Dots, Physical Review Letters, 2015, 115, 096801.

### Lorsque le régime isolé correspond au régime totalement isolé

L'isolation considérée est une isolation totale. Plus particulièrement, en reprenant la [Fig. 3], dans un couple CP de boites quantiques QD1,QD2, il est possible de distinguer la barrière de potentiel BQ entre les deux boites quantiques QD1,QD2 qui va permettre de moduler le couplage tunnel entre ces dernières de la barrière de potentielle extérieure BE qui assure le régime partiellement isolé du couple CP de boites quantiques QD1,QD2 par rapport aux réservoirs RE de particules chargées PC. Autrement dit, il est possible d'établir un couplage tunnel entre deux boites quantiques QD1,QD2 du couple CP de boites quantiques QD1,QD2 en modulant la barrière de potentiel BQ qui les sépare tout en conservant un régime partiellement isolé avec le ou les réservoirs RE de particules chargées PC.

Le régime de fonctionnement du couple CP de boites quantiques QD1,QD2 peut être caractérisé au moyen de deux paramètres : l'écart entre les niveaux d'énergie NE de chaque particule chargée PC contenue dans chaque boite quantique QD1,QD2, noté *ε*, et la valeur du paramètre Γ_{QD} associé à la barrière de potentiel BQ qui sépare les deux boites quantiques QD1,QD2 (et donc les deux particules chargées PC contenues dans les deux boites quantiques QD1,QD2). Il est possible de modifier l'un et l'autre par l'application de tensions sur des grilles de contrôle de sorte à obtenir la configuration la plus adaptée à la manipulation souhaitée. Le paramétrage de ces deux propriétés en vue d'une manipulation quantique est une technique bien connue de la personne du domaine. Un tel paramétrage est par exemple décrit dans les documents cités en introduction et ne sera donc pas répété ici par soucis de concision.

Il est possible de représenter la valeur de ces deux paramètres dans un diagramme de stabilité tel qu'illustré à la [Fig. 6]. Dans cet exemple, le paramètre Γ_{QD} peut être modulé à l'aide de la troisième tension V1' de grille, la modification correspondant à un déplacement du système selon l'axe des abscisses dans le diagramme de stabilité. De la même manière, le paramètre *ε* peut être modulé à l'aide de la quatrième tension V2' de grille, la modification de ce paramètre correspondant à un déplacement selon l'axe des ordonnées dans le diagramme de stabilité. Ainsi, dans cette représentation, deux points ayant la même abscisse correspondent à deux configurations ayant une barrière de potentiel Γ_{QD} identique entre les deux boites quantiques QD1,QD2, tandis que deux points ayant la même ordonnée correspondent à deux configurations ayant une valeur de *ε* identique. Autrement dit, contrairement au diagramme de stabilité de la [Fig. 5], le « cross-talk » n'a pas été représenté.

Par ailleurs, l'état de charge associé à l'état fondamental de chaque configuration a été représenté sur le diagramme de stabilité de la [Fig. 6]. Plus particulièrement, dans ce diagramme (et de manière plus générale dans la suite de la description), l'état de charge du couple CP de boites quantiques QD est noté (x₁, x₂) avec x₁ l'état de charge de la première boite quantique QD1 et x₂ l'état de charge de la deuxième boite quantique QD2. Il est utile de noter que le couple CP de boites quantiques QD est dans le régime partiellement isolé lors de la réalisation du diagramme de stabilité de la [Fig. 6]. Aussi, le nombre total de particules chargées PC dans le couple CP de boites quantiques QD1,QD2 est fixé. De plus, dans le diagramme de stabilité, seul le cas où l'état de charge du couple CP de boites quantiques QD est égal à deux est représentée. Autrement dit, l'état de charge du couple CP de boites quantiques QD peut prendre les états de charge suivants : (2,0), (1,1) et (0,2).

### Evaluation des points de fonctionnement correspondant à un régime isolé

Le procédé 100 comprend ensuite, à partir de ce diagramme de stabilité, une deuxième étape 1E2 d'évaluation des points de fonctionnements correspondant à un régime isolé, l'évaluation étant définie comme une détermination des points de fonctionnements correspondant au régime isolé ne faisant pas appel à une détermination du taux tunnel Γ. Le terme d'évaluation est utilisé ici pour faire apparaitre qu'il existe une méthode plus précise (décrite dans la suite) pour déterminer ces points de fonctionnement. De plus, la durée de référence pour évaluer le régime d'isolé est fixé par la méthode utilisée pour réaliser le diagramme de stabilité et cette durée de référence ne correspond pas nécessairement à la durée de référence évoquée dans le préambule. Cependant, l'évaluation de la position de ces points de fonctionnement à partir du diagramme de stabilité fournie une bonne approximation.

### Lorsque le régime isolé correspond au régime partiellement isolé

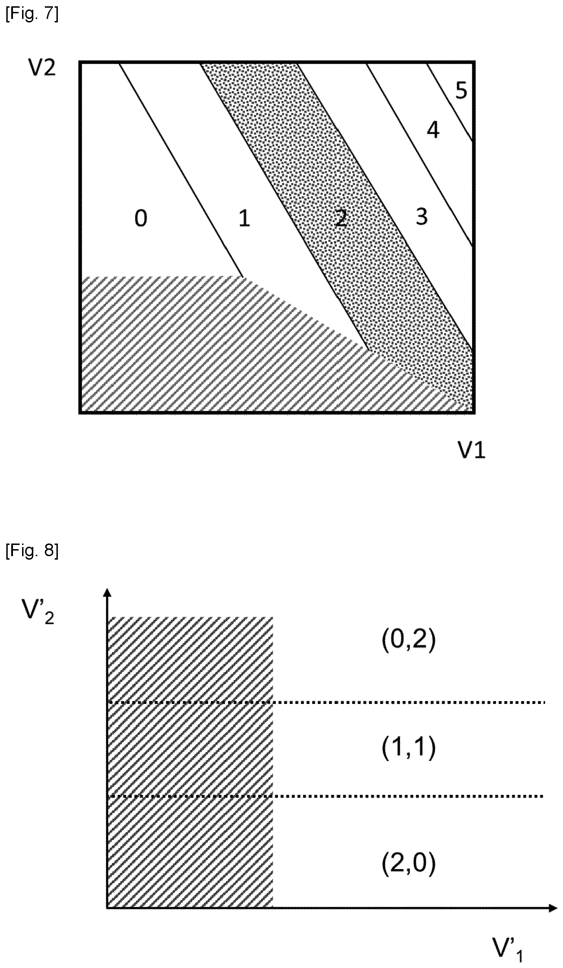

L'isolation considérée est une isolation partielle. Comme illustré à la [Fig. 7], à partir du diagramme de stabilité de la [Fig. 3], il est possible d'identifier une première région qui correspond à un régime dans lequel le couple CP de boites quantiques QD est partiellement isolé (représentée en hachuré sur la [Fig. 7]) et une deuxième région dans laquelle le couple CP de boites quantiques QD peut se charger ou se décharger en particules chargées PC par l'intermédiaire du ou des réservoirs RE (région en dehors de la région hachurée). Au sein de cette deuxième région, il est possible d'identifier une zone pour laquelle deux particules chargées PC sont présentes dans le couple CP de boites quantiques QD (représentée en pointillés sur la [Fig. 7]).

Il est donc possible, à partir d'un tel diagramme, d'estimer la position des points Pi de fonctionnement correspondant au régime partiellement isolé du couple CP de boites quantiques QD et les points Pi de fonctionnement correspondant au chargement de deux particules chargées PC dans le couple CP de boites quantiques QD.

### Lorsque le régime isolé correspond au régime totalement isolé

L'isolation considérée est une isolation totale. Comme illustré à la [Fig. 8], à partir du diagramme de stabilité de la [Fig. 5], il est possible de déterminer une région qui correspond au régime d'isolation totale, par exemple en examinant la stochastique des lignes de transition marquant le changement d'un état de charge. Lorsqu'une telle transition se fait dans le régime totalement isolé, ces lignes tendent à disparaitre (même si ces dernières sont toujours représentées sur les figures par soucis de clarté).

Lorsque l'on souhaite s'affranchir de l'aspect grossier lié à l'évaluation de la stochastique des lignes de changement d'état de charge, il est possible d'envisager une évaluation plus précise comme cela va être décrit maintenant.

Tout d'abord, une pluralité de points de fonctionnement finaux Cⁱ_{final} est choisie, chaque point de fonctionnement final Cⁱ_{final} correspondant à une valeur différente du premier paramètre Γ_{QD} des autres points de fonctionnement finaux Cⁱ_{final} de la pluralité de points de fonctionnement finaux Cⁱ_{final} de sorte à couvrir l'ensemble des valeurs du premier paramètre Γ_{QD} que peut prendre le couple CP de boites quantiques QD1,QD2 ou, tout du moins, que l'on souhaite caractériser. Par ailleurs, l'état de charge à l'état fondamental est connu pour chaque configuration finale.

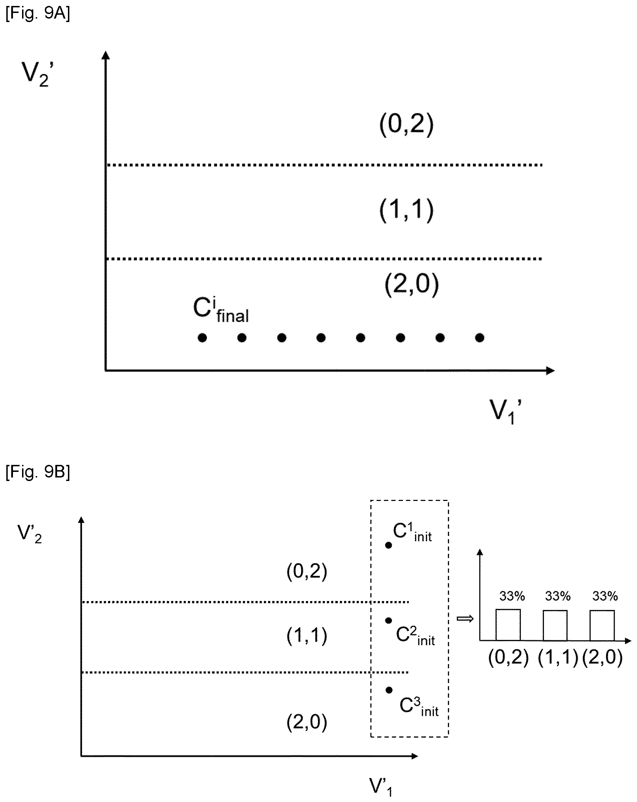

Une telle pluralité de points de fonctionnement finaux Cⁱ_{final} est illustrée à la [Fig. 9A] (huit points de fonctionnement finaux Cⁱ_{final} dans cet exemple). Dans l'exemple donné, tous les points de fonctionnement finaux Cⁱ_{final} sont associées à un même état de charge (2,0). Cependant, un point de fonctionnement final peut être associée à n'importe lequel des trois états de charge que peut prendre le couple CP de boites quantiques QD1,QD2.

En outre, pour chaque point de fonctionnent final Cⁱ_{final} de la pluralité de points de fonctionnement finaux Cⁱ_{final}, une pluralité de points de fonctionnement initiaux Cⁱᵢₙᵢₜ va être considérée. Cette pluralité de point de fonctionnement initiaux Cⁱᵢₙᵢₜ correspond à une distribution d'états de charge connue. Par exemple, si la pluralité de points de fonctionnement initiaux Cⁱᵢₙᵢₜ comprend douze points de fonctionnement, il sera possible de choisir une distribution de charge dans laquelle quatre points de fonctionnement initiaux Cⁱᵢₙᵢₜ correspondent à un état de charge (2,0), quatre points de fonctionnement initiaux Cⁱᵢₙᵢₜ correspondent à un état de charge (1,1) et quatre points de fonctionnement initiaux Cⁱᵢₙᵢₜ correspondent à un état de charge (0,2). Un exemple de trois points de fonctionnement initiaux Cⁱᵢₙᵢₜ est donné à la [Fig. 9B] dans lequel chaque point de fonctionnement initial Cⁱᵢₙᵢₜ correspond à un état de charge donné différent des deux autres points de fonctionnement initiaux Cⁱᵢₙᵢₜ. Il est possible d'associer à ces trois points de fonctionnement initiaux Cⁱᵢₙᵢₜ une distribution des états de charge initiale comme illustré sur la [Fig. 9B] à droite dans laquelle, par exemple, chaque état de charge est associé à une probabilité de 33%. Afin d'avoir une estimation de la position des points de fonctionnement associée au régime totalement isolée, pour chacun des points de fonctionnement initiaux Cⁱᵢₙᵢₜ, les sous-étapes qui vont être décrites maintenant sont mises en œuvre.

Tout d'abord, une sous-étape d'initialisation du couple CP de boites quantiques QD1,QD2 dans un premier point de fonctionnement correspondant au point de fonctionnement initial Cⁱᵢₙᵢₜ considéré est mise en œuvre. A l'issue de cette sous-étape d'initialisation, le couple CP de boites quantiques QD1,QD2 est dans l'état de charge fondamental associé au point de fonctionnement initial Cⁱᵢₙᵢₜ. Par exemple, sur la [Fig. 9B], l'état de charge du couple de boites quantiques lors de la sous-étape d'initialisation est (0,2) pour le premier point de fonctionnement initial C¹ᵢₙᵢₜ, (1,1) pour le deuxième point de fonctionnement initial C¹ᵢₙᵢₜ et (2,0) pour le troisième point de fonctionnement initial C¹ᵢₙᵢₜ.

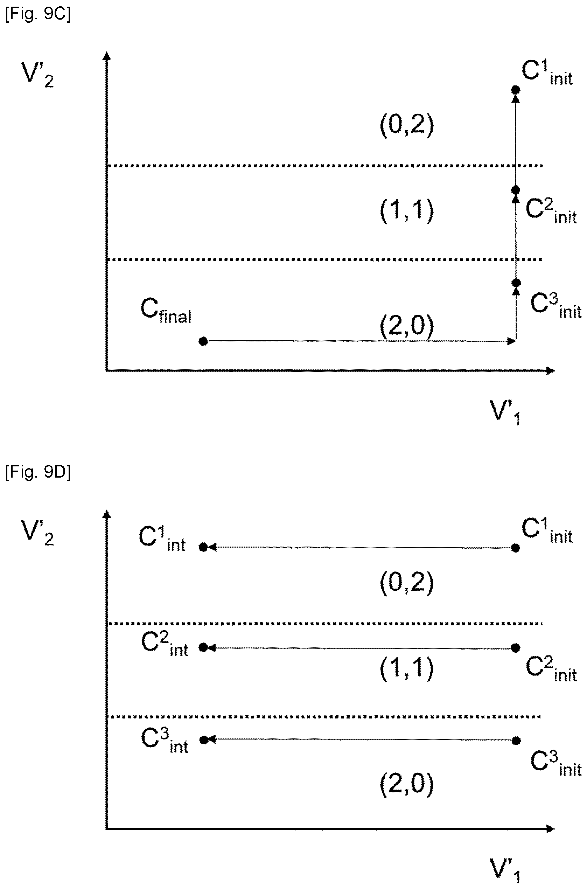

Comme illustré à la [Fig. 9C] pour trois points de fonctionnement initiaux Cⁱᵢₙᵢₜ, la sous-étape d'initialisation est mise en œuvre à partir du point de fonctionnement final C_{final} considéré et comprend :
- une première phase d'augmentation du premier paramètre Γ_{QD} jusqu'à la valeur relative au point de fonctionnement initial souhaité, la valeur du deuxième paramètre *ε* n'étant pas modifiée lors de cette première phase ;
- Une deuxième phase de variation du deuxième paramètre *ε* jusqu'à la valeur relative au point de fonctionnement initial souhaité, la valeur du première paramètre Γ_{QD} n'étant pas modifiée lors de cette deuxième phase.

Comme illustré à la [Fig. 9D], une sous-étape de diminution du premier paramètre Γ_{QD} (c'est-à-dire une augmentation de la barrière tunnel séparant la première boite quantique QD1 de la deuxième boite quantique QD2) est ensuite mise en œuvre, le couple CP de boites quantiques QD1,QD2 étant dans un deuxième point de fonctionnement, dit point de fonctionnement intermédiaire Cⁱᵢₙₜ, à l'issue de cette sous-étape, la valeur du premier paramètre Γ_{QD} du point de fonctionnement intermédiaire Cⁱᵢₙₜ étant égale à la valeur du premier paramètre Γ_{QD} du point de fonctionnement final Cⁱ_{final} considérée.

Il est utile de noter que seule la valeur du première paramètre Γ_{QD} est modifiée et que donc la valeur du deuxième paramètre *ε* du point de fonctionnent intermédiaire Cⁱᵢₙₜ est égale à la valeur du deuxième paramètre *ε* du point de fonctionnement initial Cⁱᵢₙᵢₜ. Aussi, l'état de charge fondamental associé au point de fonctionnement intermédiaire Cⁱᵢₙₜ est identique à l'état de charge fondamental associé au point de fonctionnement initial Cⁱᵢₙᵢₜ. Autrement dit, l'état de charge du couple de boites quantiques QD1,QD2 n'est pas modifié lors de cette sous-étape. Par exemple, sur la [Fig. 9D], l'état de charge du couple CP de boites quantiques QD1,QD2 à l'issue de l'étape de diminution du premier paramètre Γ*_{QD}* est (0,2) pour le premier point de fonctionnement C¹ᵢₙₜ, (1,1) pour le deuxième point de fonctionnement intermédiaire C²ᵢₙₜ et (2,0) pour le troisième point de fonctionnement intermédiaire C³ᵢₙₜ.

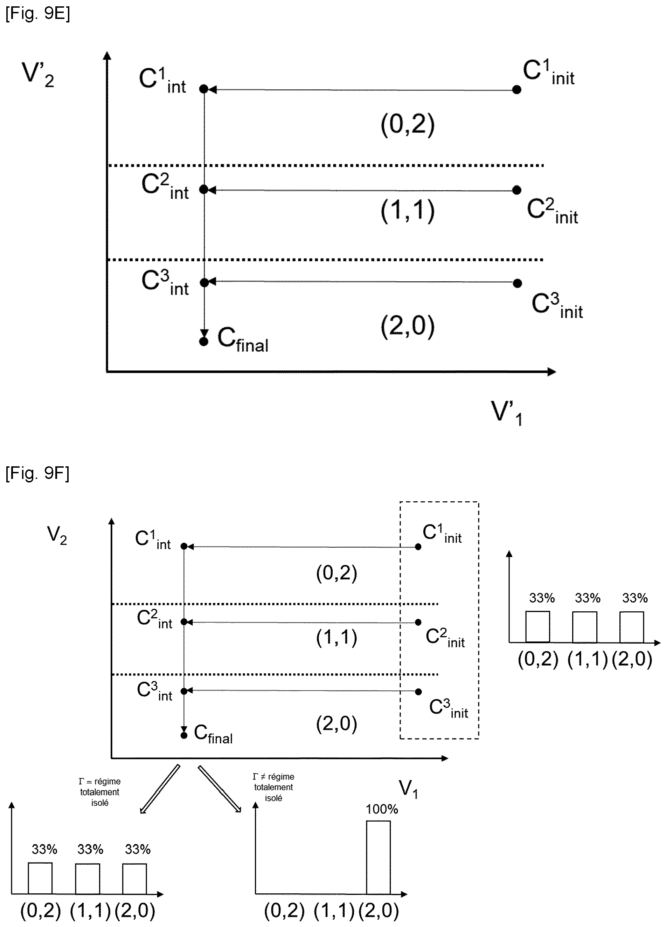

Comme illustré à la [Fig. 9E], une sous-étape de variation du deuxième paramètre *ε* est ensuite mise en œuvre, la valeur du premier paramètre Γ_{QD} étant conservée lors de cette sous-étape, le système SYS étant dans un troisième point de fonctionnement correspondant au point de fonctionnement final C_{final} considéré à l'issue de cette sous-étape. Il est utile de noter que, lors de cette sous-étape, la valeur du premier paramètre Γ_{QD} n'est pas modifiée et que donc la barrière de potentiel séparant les deux boites quantiques QD1,QD2 du couple CP de boites quantiques QD1,QD2 n'est pas modifiée. En revanche, la valeur du paramètre *ε* étant modifiée, l'état de charge fondamental associé au point de fonctionnement final C_{final} peut être différent de l'état de charge fondamental associé au point de fonctionnement initial Cⁱᵢₙᵢₜ (et dans lequel se trouve le système à l'issue de la sous-étape d'initialisation).

Il est possible d'examiner deux cas de figure : le premier cas où la valeur du premier paramètre Γ_{QD} lors de cette sous-étape correspond au régime totalement isolé et le deuxième cas où la valeur du premier paramètre Γ_{QD} lors de cette étape ne correspond pas au régime totalement isolé. Ces deux cas de figure sont schématisés à la [Fig. 9F].

Dans le premier cas, aucun transfert de charge n'est possible entre la première boite quantique QD1 et la deuxième boite quantique QD2. Aussi, même si le point de fonctionnement final C_{final} est associée à un état de charge fondamental différent de l'état de charge fondamental associée au point de fonctionnement initial Cⁱᵢₙᵢₜ, cet état de charge n'est pas modifié lors de la sous-étape de variation du deuxième paramètre *ε*. Par exemple, sur la [Fig. 9F], l'état de charge du couple CP de boites quantiques QD1,QD2 à l'issue de la sous-étape de variation du deuxième paramètre *ε* est (0,2) pour le système initialement (c'est-à-dire au début de la sous-étape 2E3 de variation du deuxième paramètre *ε*) au premier point de fonctionnement intermédiaire C¹ᵢₙₜ, (1,1) pour le système initialement au deuxième point de fonctionnement intermédiaire C²ᵢₙₜ et (2,0) pour le système initialement au troisième point de fonctionnement intermédiaire C³ᵢₙₜ. Il ressort de ce qui précède que, dans ce premier cas, la distribution des états de charge initiale sera conservée. Autrement dit la probabilité associée un état de charge à l'état initial est égale à la probabilité associé audit état de charge à l'état final.

Dans le deuxième cas, un transfert de charge est possible entre la première boite quantique QD1 et la deuxième boite quantique QD2. Aussi, si le point de fonctionnement final C_{final} est associée un état de charge fondamental différent de l'état de charge fondamental associée au point de fonctionnement initial Cⁱᵢₙᵢₜ, ce dernier est modifié lors de la sous-étape de variation du deuxième paramètre *ε*. Par exemple, sur la [Fig. 9F], l'état de charge du système à l'issue de la sous-étape de variation du deuxième paramètre *ε* est (2,0) quelle que soit le point de fonctionnement intermédiaire Cⁱᵢₙₜ (et donc le point de fonctionnement initial) considéré. Il ressort de ce qui précède que, dans ce deuxième cas, la distribution des états de charge initiale ne sera pas conservée. Autrement dit la probabilité associée un état de charge à l'état initial est différente de la probabilité associé audit état de charge à l'état final.

Afin de pouvoir établir l'état de charge du système au point de fonctionnement final C_{final}, une sous-étape de détermination de l'état de charge du système au point de fonctionnement final C_{final} est donc mise en œuvre.

Comme mentionné précédemment, ces sous-étapes sont réalisées pour une pluralité de point de fonctionnement initiaux Cⁱᵢₙᵢₜ. Il est donc possible de constituer une statistique des états de charge mesurés au point de fonctionnement final C_{final} de sorte à déterminer une distribution des états de charge mesurés au point de fonctionnement final C_{final} (et donc la probabilité associée à chaque état de charge au point de fonctionnement final). Pour cela une sous-étape de détermination de la distribution des états de charge mesurés au point de fonctionnement final C_{final} est mise en œuvre.

Comme déjà détaillé, si la valeur du premier paramètre Γ_{QD} correspond à un régime totalement isolé, alors la distribution des états de charges mesurés au point de fonctionnement final C_{final} sera sensiblement identique à la distribution des états de charge initiale. Aussi, une sous-étape de comparaison de la distribution des états de charge initiale à la distribution des états de charges mesurés au point de fonctionnement final C_{final} est mise en œuvre, la valeur du premier paramètre Γ_{QD} du point de fonctionnement final C_{final} correspondant à un régime totalement isolé si les deux distributions sont sensiblement identiques.

La distribution initiale et la distribution finale sont sensiblement identiques si, pour chaque état de charge, la probabilité associée à cet état de charge pour le point de fonctionnement initial est identique à la probabilité associée à cet état de charge pour le point de fonctionnement final. La probabilité initiale est identique à la probabilité finale lorsque la différence en valeur absolue entre les deux probabilités est inférieure ou égale à 10% de la valeur initiale, voire inférieure 1% de la valeur initiale, voire encore inférieure ou égale à 0.1% de la valeur initiale.

Par ailleurs, ces différentes sous-étapes étant répétées pour une pluralité de points de fonctionnement finaux Cⁱ_{final} et donc, pour une pluralité de valeurs du premier paramètre Γ_{QD}, il possible d'évaluer la position du régime totalement isolée du couple CP de boites quantiques QD1,QD2.

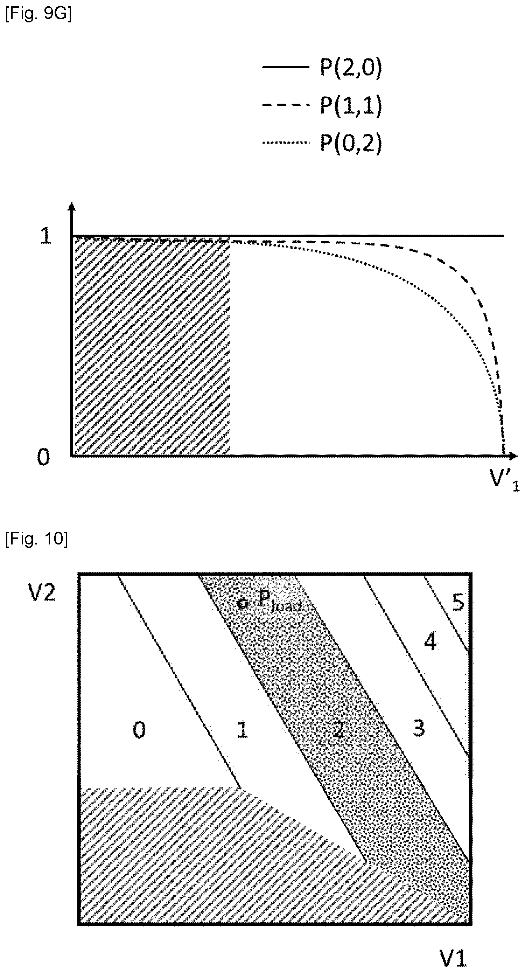

A partir des statistiques ainsi obtenues, il est ensuite possible de déterminer, pour un point de fonctionnement final donné et donc un état de charge donnée, par exemple (2,0), la probabilité que l'état de charge associé au point de fonctionnement initial soit conservé (c'est-à-dire mesuré lors de la sous-étape de détermination de l'état de charge du couple de boites quantiques au point de fonctionnement final C_{final}) en fonction de la valeur du premier paramètre Γ_{QD}. Une telle probabilité est illustrée à la [Fig. 9G] pour les trois états de charge initiaux différents. A partir de cette courbe, il est ensuite possible de déterminer les valeurs de la première tension V1' correspondant permettant d'obtenir des valeurs du premier paramètre Γ_{QD} correspondant à un régiment totalement isolé et illustrées par la zone hachurée de la [Fig. 8] et de la [Fig. 9G]. Pour rappel, le paramètre Γ_{RQ} est considéré comme correspondant à un régime totalement isolé si
[Math. 5] $\frac{1}{{τ}_{op}} ≫ {Γ}_{QD}$

Par exemple,
[Math. 6] $\frac{1}{{τ}_{op}} > {α}_{RI} \times {Γ}_{QD}$
où *α_{RI}* est un coefficient permettant de définir la tolérance à l'erreur et *τₒₚ* est la durée de référence durant laquelle le couple CP de boites quantiques QD doit être considérée comme étant en régime totalement isolé. Dans un exemple de réalisation, *α_{RI}* = 100.

### Sélection d'un point de fonctionnement en dehors du régime isolé

Une fois l'estimation de la position du régime isolé effectuée, il est possible de déterminer un premier point de fonctionnement P_{load} évalué comme étant en dehors de ce régime isolé, c'est-à-dire dans un régime pour lequel un échange de particule chargée PC peut avoir lieu entre la premier sous-système CP/QD1 et le deuxième sous-système RE/QD2. Il est également possible d'associer un état de charge, dit premier état de charge, à ce premier point de fonctionnement P_{load}.

### Lorsque le régime isolé correspond au régime partiellement isolé

L'isolation considérée est une isolation partielle. Comme illustré à la [Fig. 10], le premier point de fonctionnement P_{load} est associé à un état de charge de 2.

### Lorsque le régime isolé correspond au régime totalement isolé

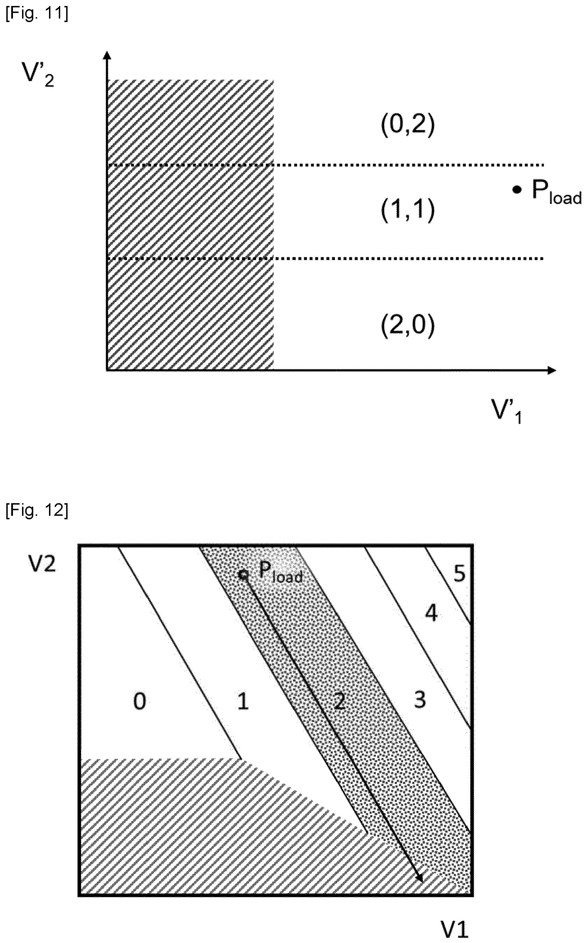

L'isolation considérée est une isolation totale. Comme illustré à la [Fig. 11], le premier point de fonctionnement P_{load} est associé à un état de charge de (1,1), chaque boite quantique QD1,QD2 du couple CP de boites quantiques QD contenant une particule chargée PC.

### Première modification du point de fonctionnement à état de charge constant

Le procédé 100 selon l'invention comprend, à partir du premier point de fonctionnement P_{load}, une étape 1E3 de modification du point de fonctionnement de sorte à obtenir un deuxième point de fonctionnement dans un régime évalué comme étant le régime isolé lors de l'étape 1E2 d'évaluation et correspondant au premier état de charge.

### Lorsque le régime isolé correspond au régime partiellement isolé

Comme illustré à la [Fig. 12], quand l'isolation considérée est une isolation partielle, durant cette étape 1E3, le point de fonctionnement est modifié à partir du premier point de fonctionnement P_{load} de sorte à obtenir un deuxième point de fonctionnement, ce deuxième point de fonctionnement étant associé, comme le premier point de fonctionnement P_{load}, à un état de charge de 2.

### Lorsque le régime isolé correspond au régime totalement isolé

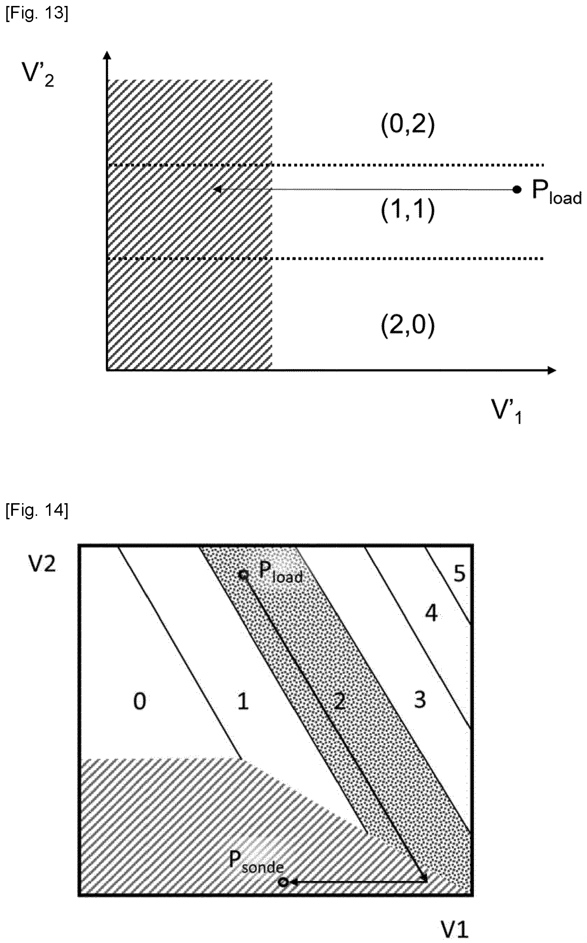

Comme illustré à la [Fig. 13], quand l'isolation considérée est une isolation totale, durant cette étape 1E3, le point de fonctionnement est modifié à partir du premier point de fonctionnement P_{load} de sorte à obtenir un deuxième point de fonctionnement, ce deuxième point de fonctionnement étant associé, comme le premier point de fonctionnement P_{load}, à un état de charge de (1,1).

### Deuxième modification du point de fonctionnement associé à un changement d'état de charge constant

Le procédé 100 comprend ensuite, à partir du deuxième point de fonctionnement, une étape 1E4 de modification du point de fonctionnement de sorte à obtenir un troisième point de fonctionnement P_{sonde}, ledit troisième point de fonctionnement P_{sonde} étant dans un régime évalué comme étant le régime isolé lors de l'étape 1E2 d'évaluation et correspondant à un deuxième état de charge différent du premier état de charge. On notera que le point de fonctionnement demeurant dans un régime estimé comme étant un régime isolé lors de cette étape, l'état de charge réel du premier sous-système CP,QD1 peut être différent de l'état de charge associé au troisième point de fonctionnement P_{sonde}, c'est-à-dire le deuxième état de charge associé à l'état fondamental du système pour ce point de fonctionnement P_{sonde} (et mentionné sur le diagramme de stabilité). C'est le régime de ce troisième point de fonctionnement P_{sonde} que l'on cherche à caractériser, c'est-à-dire déterminer si ce troisième point de fonctionnement P_{sonde} est associé à un régime isolé.

### Lorsque le régime isolé correspond au régime partiellement isolé

Comme illustré à la [Fig. 14], quand l'isolation considérée est une isolation partielle, durant cette étape 1E4, le point de fonctionnement est modifié à partir du deuxième point de fonctionnement de sorte à obtenir un troisième point de fonctionnement P_{sonde} correspondant à l'état de charge 0 différent du premier état de charge 2.

### Lorsque le régime isolé correspond au régime totalement isolé

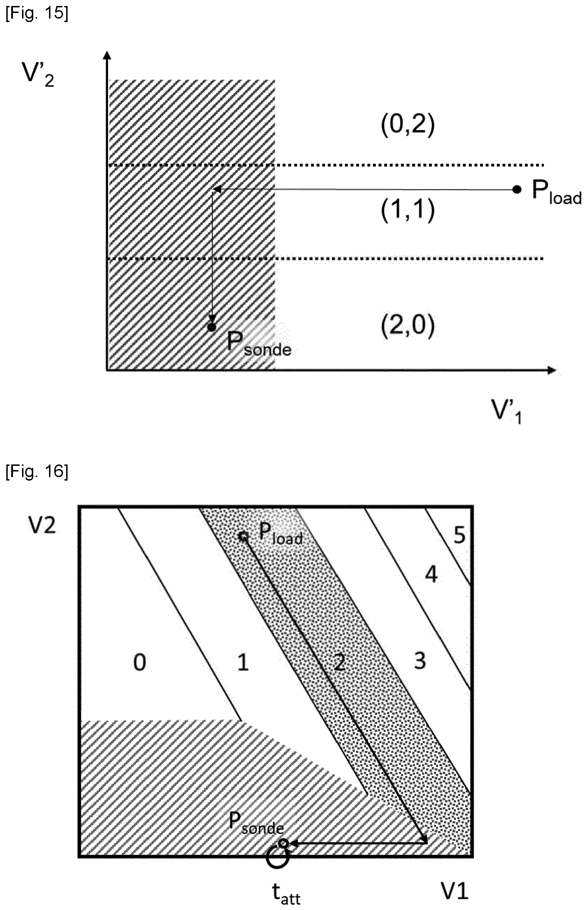

Comme illustré à la [Fig. 15], quand l'isolation considérée est une isolation totale, durant cette étape 1E4, le point de fonctionnement est modifié à partir du deuxième point de fonctionnement de sorte à obtenir un troisième point de fonctionnement P_{sonde} correspondant à l'état de charge (2,0) différent du premier état de charge (1,1).

### Attente au troisième point de fonctionnement

Le procédé 100 comprend également, au troisième point de fonctionnement P_{sonde}, une étape 1E5 d'attente durant une durée prédéterminée notée *tₐₜₜ.*

### Lorsque le régime isolé correspond au régime partiellement isolé

Comme illustré à la [Fig. 16], quand l'isolation considérée est une isolation partielle, durant cette étape 1E5, le point de fonctionnement demeure au troisième point de fonctionnement P_{sonde} correspondant à l'état de charge 0 différent du premier état de charge 2 pendant le temps d'attente *tₐₜₜ.*

### Lorsque le régime isolé correspond au régime totalement isolé

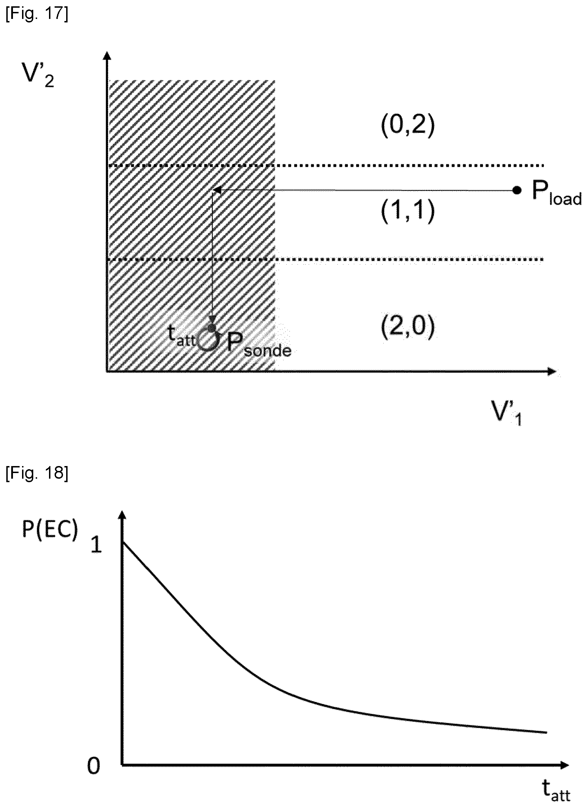

Comme illustré à la [Fig. 17], quand l'isolation considérée est une isolation totale, durant cette étape 1E5, le système demeure au troisième point de fonctionnement P_{sonde} correspondant à l'état de charge (2,0) différent du premier état de charge (1,1) pendant le temps d'attente *tₐₜₜ.*

### Détermination de l'état de charge

Le procédé 100 comprend aussi au troisième point de fonctionnement Pᵢₛₒ, une étape 1E6 de détermination de l'état de charge du premier système CP,QD1.

### Lorsque le régime isolé correspond au régime partiellement isolé

Quand l'isolation considérée est une isolation partielle, durant cette étape 1E6, l'état de charge du couple CP de boite quantique est déterminé.

### Lorsque le régime isolé correspond au régime totalement isolé

Quand l'isolation considérée est une isolation totale, durant cette étape 1E6, l'état de charge de la première boite quantique QD1 (et/ou de la deuxième boite quantique QD2) est déterminé.

### Répétition pour une pluralité de temps d'attente

Dans le procédé 100à l'issue de la détermination de l'état de charge du premier sous-système, le point de fonctionnement du système SYS est réinitialisé au premier point de fonctionnement P_{load}. La réinitialisation se fait de préférence en appliquant les modifications inverses de celles qui ont amené le point de fonctionnement du premier point de fonctionnement P_{load} au deuxième point de fonctionnement P_{sonde}.

De plus, les quatre étapes 1E3-1E6 précédentes sont répétées pour une pluralité de temps d'attente et une pluralité de fois pour chacun de ces temps d'attente de sorte à déterminer la probabilité de mesurer le premier état de charge en fonction du temp d'attente et ainsi déterminer le taux tunnel Γ associé au troisième point de fonctionnement P_{sonde}.

Autrement dit, pour chaque temps d'attente, une statistique de l'état de charge mesuré va être constituée de sorte à pouvoir déterminer la probabilité de mesurer le premier état de charge après le temps d'attente considéré. Puis, cette opération va être répétée pour une pluralité de temps d'attente de sorte à pouvoir déterminer la probabilité de mesurer le premier état de charge en fonction du temps d'attente.

L'évolution de cette probabilité est illustrée à la [Fig.18] où la probabilité associée au premier état de charge est noté P(EC). En outre, la décroissance de cette probabilité permet de déterminer le taux tunnel Γ associé à la barrière de potentiel séparant les deux sous-systèmes. A partir de cette décroissance, il est donc possible de déterminer le taux tunnel Γ associé au troisième point de fonctionnement P_{sonde}.

### Lorsque le régime isolé correspond au régime partiellement isolé

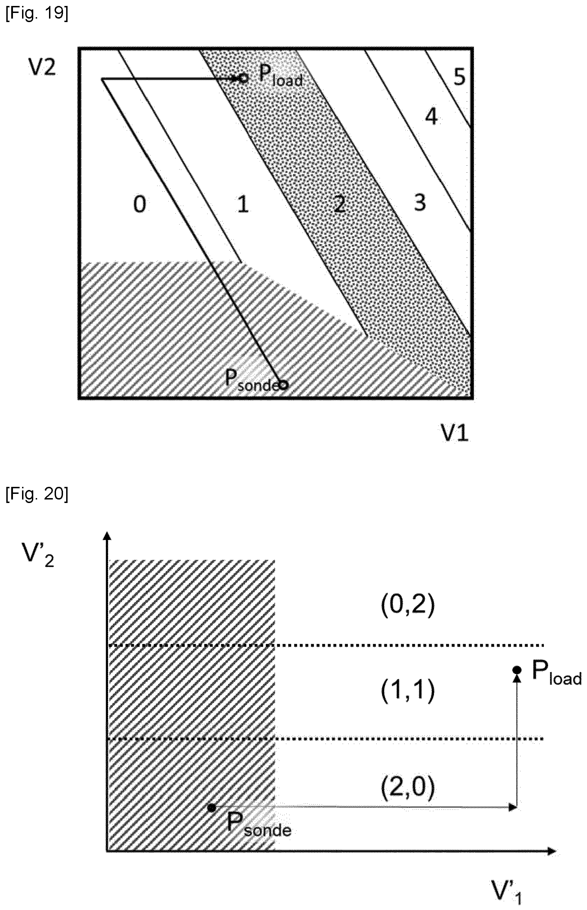

Quand l'isolation considérée est une isolation partielle, le trajet du point de fonctionnement lors de la réinitialisation est illustré à la [Fig. 19]. De plus, la probabilité mesurée en fonction du temps d'attente est la probabilité de mesurer le couple de boite quantique dans l'état de charge 2.

### Lorsque le régime isolé correspond au régime totalement isolé

Quand l'isolation considérée est une isolation totale, le trajet du point de fonctionnement lors de la réinitialisation est illustré à la [Fig. 20]. De plus, la probabilité mesurée en fonction du temps d'attente est la probabilité de mesurer la première boite quantique dans l'état de charge 1 (ou, dit autrement, le couple de boite quantique dans l'état de charge (1,1)). Une fois que la valeur du paramètre Γ est connu, il convient de déterminer si cette dernière correspond à un régime isolé pour la durée de référence ou s'il est nécessaire d'examiner un nouveau point de fonctionnement.

### Détermination conditionnelle d'un nouveau troisième point de fonctionnement

Pour cela, le procédé 100 comprend, lorsque la valeur du taux tunnel Γ est telle que $que \frac{1}{{τ}_{op}} \geq {α}_{RI} Γ$ avec *τₒₚ* la durée de référence et *α_{RI}* un coefficient de tolérance, une étape 1E7 de détermination d'un nouveau troisième point de fonctionnement Pᵢₛₒ, les étapes 1E3-1E6 permettant la détermination du taux tunnel Γ associé à ce nouveau troisième point de fonctionnement P_{sonde} étant à nouveau mises en œuvre.

En effet, lorsque la relation précédente est vérifiée, cela signifie que le troisième point de fonctionnement P_{sonde} ne peut pas être associé à un régime isolé pour la durée de référence *τₒₚ* considérée. Autrement dit, les étapes 1E3-1E6 permettant la détermination du taux tunnel Γ pourront être réitérées une pluralité de fois jusqu'à l'obtention d'un troisième point de fonctionnement P_{sonde} associé à un régime isolé pour la durée de référence considérée *τₒₚ.* Plus généralement, tous les points de fonctionnement associé au même taux tunnel Γ que le point de fonctionnement ainsi déterminé ou à un taux tunnel plus faible pourront être considérés comme des points de fonctionnement associés au régime isolé.

### Détermination conditionnelle du régime isolé du troisième point de fonctionnement.

De manière complémentaire, le procédé 100 selon l'invention comprend, lorsque la valeur du taux tunnel Γ est telle que $\frac{1}{{τ}_{op}} < {α}_{RI} Γ$*,* une étape 1E8 de sélection du troisième point de fonctionnement P_{sonde} comme point de fonctionnement dans le régime isolé. De plus, tous les points de fonctionnement associés à un taux tunnel Γ égal ou plus faible que celui du troisième point de fonctionnement ainsi sélectionné pourront également être associés à un régime isolé.

En effet, lorsque la relation précédente est vérifiée, cela signifie que le troisième point de fonctionnement P_{sonde} peut être associé à un régime isolé pour la durée de référence *τₒₚ* considérée.

### Résultats

A l'issue du procédé 100 selon l'invention, un point de fonctionnement associé à un régime isolé pour la durée de référence *τₒₚ* considérée a été déterminé. De plus, à partir de position de ce point de fonctionnement, il est possible de déterminer une pluralité d'autres points de fonctionnement présentant un taux tunnel inférieur ou égal au point de fonctionnent ainsi déterminé et pouvant donc également être associé à un régime isolé. Comme cela apparaitra dans la suite, la connaissance d'un tel point de fonctionnement peut être utilisé afin de mieux caractériser les différents régimes de fonctionnement d'un système SYS selon l'invention.

### Procédé de détermination d'un point de fonctionnement associé au chargement de deux particules chargées dans l'état singulet

### Rappel concernant les propriétés magnétique d'un système à deux particules chargées

Les rappels qui vont être faits ici abordent des notions bien connues de la personne du domaine et ne sont introduites ici que pour faciliter la compréhension de l'invention par une personne non initiée.

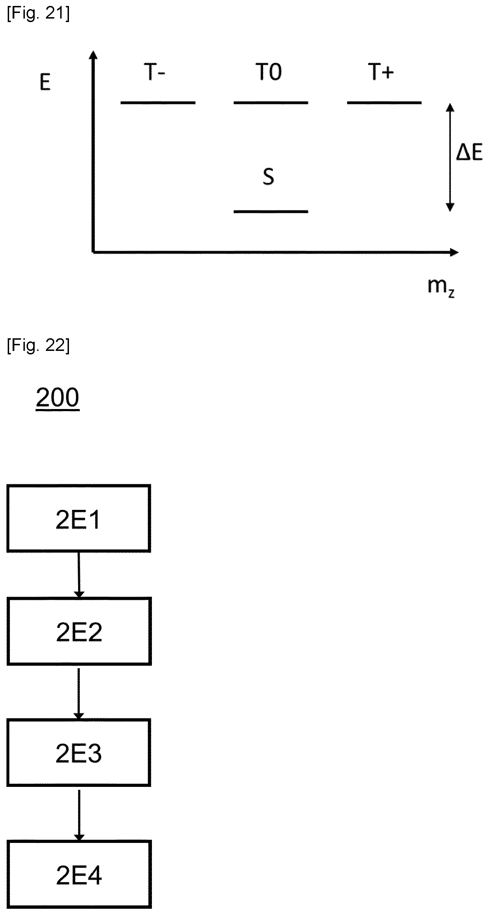

Lorsque deux particules chargées PC sont couplées l'une à l'autre (on parle d'interaction d'échange), elles forment quatre états de spin : un état singulet (ou singlet en anglais) et trois état triplets. Une représentation énergétique de ces états est proposée à la [Fig. 21]. Dans la suite, S correspond à l'état singulet, T- correspond à l'état triplet ayant une composante selon z (noté m_{z}) égale à -1, T0 correspond à l'état triplet ayant une composante selon z nulle et T+ correspond à l'état triplet ayant une composante selon z égale à +1 (il s'agit de la notation généralement utilisée dans le domaine). La différence en énergie noté Δ*E* qui sépare les états triplets de l'état singulet est largement supérieure à la température d'utilisation d'un système SYS selon l'invention et cette énergie ne peut donc pas être fournie par l'agitation thermique. Du fait de cette différence, il existe des points de fonctionnement Pi pour lesquelles le chargement de deux particules chargées PC ne peut se faire qu'à condition que les particules chargées PC adoptent un état singulet S dans le couple CP de boites quantiques QD.

Afin de déterminer les points de fonctionnement permettant de charger deux particules chargées PC dans l'état singulet S, un deuxième aspect illustré à la [Fig. 22] concerne un procédé 200 de détermination d'au moins un point de fonctionnement (en général, une pluralité de ces points de fonctionnement sont déterminés) associé au chargement de deux particules chargées PC dans l'état singulet dans un couple CP de boites quantiques QD d'un système à partir d'un point de fonctionnement, dit point de fonctionnement de lecture Pᵢₛₒ, associé au régime partiellement isolé par rapport à une durée de référence supérieure ou égale à la durée nécessaire à la modification du point de fonctionnement, à la mesure du signal du moyen de mesure et à l'attente (ces étapes seront décrites dans la suite). Ce point de fonctionnement est destiné à être utilisée pour la lecture de l'état de charge du couple CP de boites quantiques QD.

### Détermination du point de fonctionnement de lecture

Le point de fonctionnement de lecture Pᵢₛₒ est déjà connu et a été déterminé par un procédé selon l'invention ou tout autre procédé. Il n'est donc pas nécessaire de le déterminer.

En revanche, lorsque ce dernier n'est pas connu, le procédé 200 comprend une étape de détermination d'un point de fonctionnement dans un régime partiellement isolé Pᵢₛₒ dans lequel, pour la durée de référence, aucun échange de particule chargée PC n'est possible entre le couple CP de boites quantiques QD et le réservoir RE de particules chargées PC. Ce point de fonctionnement Pᵢₛₒ sera désigné dans la suite de la description du procédé 200 par le terme point de fonctionnement de lecture.

Le point de fonctionnement de lecture Pᵢₛₒ est déterminé à l'aide d'un procédé 100 selon un premier aspect dans lequel le couple CP de boites quantiques QD ou une boite quantique QD1 du couple CP de boites quantiques QD est le premier sous-système et dans lequel le réservoir RE de particules chargées PC est le deuxième sous-système, le premier état de charge correspond à la présence de deux particules chargées PC dans le couple CP de boites quantiques QD ou dans la boite quantique QD1 du couple CP de boites quantiques QD, le point de fonctionnement Pᵢₛₒ ainsi déterminé étant désigné comme point de fonctionnement de lecture de l'état de charge.

Bien entendu, tout procédé permettant d'identifier un point de fonctionnement de lecture Pᵢₛₒ dans le régime partiellement isolé peut être utilisé.

Le procédé 200 comprend ensuite, à partir du point de fonctionnement de lecture Pᵢₛₒ ainsi déterminé et pour une pluralité de points de fonctionnement, dit points de fonctionnement de chargement P_{load}, associé à un état de charge de deux particules chargée PC les étapes 2E1-2E4 suivantes.

Le procédé 200 selon l'invention comprend une étape 2E1 de modification du point de fonctionnement du couple CP de boites quantiques QD de sorte à adopter le point de fonctionnement de chargement P_{load} considérée, la modification se faisant selon un premier parcours, dit parcours de chargement T1.

Cette étape de modification du point de fonctionnement 2E1 est suivie d'une étape 2E2 d'attente au point de fonctionnement de chargement P_{load} pendant une durée prédéterminée. La durée prédéterminée est choisie grande (par exemple dix fois plus grande, voire cent fois plus grande) comparée à la vitesse nécessaire au parcours du trajet de chargement et du trajet de lecture.

Puis, le procédé 200 comprend une étape 2E3 de modification du point de fonctionnement du couple CP de boite quantique QD de sorte à adopter le point de fonctionnement de lecture Pᵢₛₒ, la modification se faisant selon un deuxième parcours T1' inverse du parcours de chargement T1, dit parcours de lecture. On entend par parcours inverse le fait que le deuxième parcours correspond au premier parcours pour lequel la flèche du temps est inversée.

Cette étape est elle-même suivie d'une étape 2E4 de détermination de l'état de charge du couple de boite quantique ou de la boite quantique du couple de boites quantiques QD, la détermination de l'état de charge se faisant au point de fonctionnement de lecture Pᵢₛₒ.

### Points de fonctionnement associés au chargement de deux particules chargées dans l'état singulet

Le point de fonctionnement de chargement P_{load} est associé au chargement d'un état singulet S si l'état de charge déterminé est égal à zéro. Sinon, il est associé au chargement d'un état triplet (T- ,T0 ou T+). En effet, si le point de fonctionnement de chargement P_{load} correspond au chargement de deux particules dans l'état de spin triplet, leur chargement se fait nécessairement de façon non adiabatique (par rapport au couplage tunnel entre le réservoir de particules chargées PC et le couple CP de boites quantiques QD1). Par conséquent, le temps tunnel du réservoir RE de particules chargées PC vers le couple CP de boites quantiques QD est long (autrement dit le couplage tunnel entre le couple CP de boites quantiques QD est le réservoir RE de particules chargées PC est faible) devant le temps de trajet T1. Le temps d'attente à P_{load} permet de s'assurer du chargement des particules chargées PC quel que soit leur état de spin. En revanche, si le point de fonctionnement de chargement P_{load} correspond au chargement de deux particules chargées dans l'état de spin triplet, alors les particules chargées PC ne seront pas échangées avec le réservoir RE de particules chargées PC lors du trajet inverse T1' (elles le seront si P_{load} correspond au chargement de deux particules chargées PC dans l'état de spin singulet). Aussi, la lecture de l'état de charge zéro (0) dans le couple CP de boites quantiques QD après la séquence indique que le point de fonctionnement de chargement P_{load} correspond au chargement de deux particules chargées dans l'état de spin singulet, et la lecture d'un état de charge de un (1) ou de deux (2) indique que le point de fonctionnement de chargement P_{load} correspond au chargement de deux particules chargées dans l'état de spin triplet.

Aussi, grâces aux étapes décrites précédemment, il est possible de déterminer les points de fonctionnement de chargement de la pluralité de points de fonctionnement de chargement associés au chargement de deux particules chargées dans l'état singulet S. Par ailleurs, la durée de référence associé au point de fonctionnement dans le régime partiellement isolé est supérieure ou égale à la durée nécessaire à la modification du point de fonctionnement, la mesure du signal du moyen de mesure et l'attente.

### Définition des trajets de chargement T1 et de lecture T1'

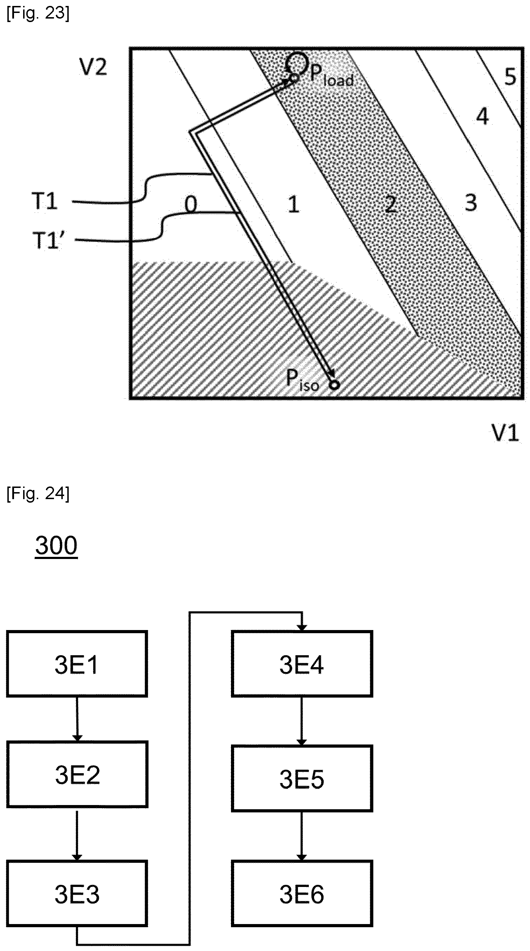

Comme illustré à la [Fig. 23], le parcours du trajet T1 comprend à partir du point de fonctionnement de lecture Pᵢₛₒ, une sous-étape de modification du point de fonctionnement de sorte à obtenir un deuxième point de fonctionnement non associé à un régime partiellement isolé et associé au même état de charge que le point de fonctionnement de lecture Pᵢₛₒ. Ce parcours comprend également, à partir du deuxième point de fonctionnement, une sous-étape de modification du point de fonctionnement de sorte à obtenir le point de fonctionnement de chargement P_{load} considéré

Le parcours du trajet T1' comprend, à partir du point de fonctionnement de chargement considéré P_{load}, une sous-étape de modification du point de fonctionnement de sorte à obtenir le troisième point de fonctionnement puis, à partir du troisième point de fonctionnement, une sous-étape de modification du point de fonctionnement de sorte à revenir au point de fonctionnement de lecture Pᵢₛₒ.

Ainsi, le trajet T1' de la [Fig. 23] correspond au trajet T1 parcouru en sens inverse. Autrement dit, le parcours T1' correspond au parcours T1 parcouru depuis le point de fonctionnement de chargement P_{load} en inversant la flèche du temps.

### Résultats

A l'issue du procédé 200 au moins un point de fonctionnement, de préférence une pluralité de points de fonctionnement, associé au chargement de deux particules chargées PC dans un état singulet est connue (il sera montré dans la suite que cette position peut encore être affinée).

### Procédé de détermination d'un jeu de paramètres d'un moyen de lecture de l'état de charge

Comme le montre les paragraphes précédents et le confirmeront les paragraphes suivants, la mesure de l'état de charge est un aspect important dans la mise en œuvre de boites quantiques pour des applications à l'informatique quantique. Il peut donc être intéressant d'optimiser les paramètres du moyen de mesure de l'état de charge.

Or, dans l'état de la technique, une telle optimisation est difficilement envisageable. En effet, la position du point de fonctionnement de lecture est souvent liée au point de fonctionnement dont on cherche à caractériser l'état de charge. Aussi, il est nécessaire de caractériser chacun des points de fonctionnement de lectures, ce qui est impossible en pratique (le temps nécessaire étant trop important). A ce titre, il est utile de rappeler que le temps associé à la lecture de l'état de charge est souvent plus long que le temps associé aux autres procédures (modifications du point de fonctionnement, conversion spin/charge, etc.).

Cependant, en utilisant un régime d'isolement pour lequel l'état de charge est pratiquement garanti de ne pas changer, il est possible d'utiliser le même point de fonctionnement de lecture quel que soit le point de fonctionnement dont on cherche à caractériser l'état de charge. Il devient alors possible d'optimiser les paramètres de lecture pour le point de fonctionnement de lecture choisi (et associé à un régime isolé). Par exemple, le ou les paramètres de mesure pourront être choisis parmi la tension de grille d'un électromètre utilisé pour la mesure, le temps d'intégration du signal mesurée, l'amplification du signal, le filtrage du signal (type de filtrage, fréquences de coupure etc.).

Ainsi, le régime isolé selon l'invention permet également d'optimiser les paramètres de fonctionnement du moyen de lecture CS permettant de déterminer l'état de charge du premier sous-système ou du deuxième sous-système.

Pour cela, un troisième aspect illustré à la [Fig. 24] concerne un procédé 300 de détermination d'un jeu de paramètres d'un moyen de mesure CS de l'état de charge d'un système SYS comprenant un premier sous-système CP,QD1 et un deuxième sous-système RE,QD2, le premier sous-système CP,QD1 et le deuxième sous-système RE,QD2 pouvant contenir zéro, une ou plusieurs particules chargées PC, un couplage tunnel existant entre le premier sous-système CP,QD1 et le deuxième sous-système RE,QD2, ledit couplage tunnel permettant l'échange d'une ou plusieurs particules chargées PC entre le premier sous-système CP,QD1 et le deuxième sous-système RE,QD2 et étant modulé par une tension de grille appliquée à une ou plusieurs grilles configurées pour former une barrière de potentiel entre le premier sous-système CP,QD1 et le deuxième sous-système RE,QD2, un point de fonctionnement du système SYS étant déterminé par la valeur prise par chaque tension de grille, le moyen de mesure CS étant configuré pour mesurer un signal fonction de l'état de charge du premier sous-système CP/QD1, le signal mesuré par le moyen de mesure de l'état de charge dépendant d'une pluralité de paramètres de mesure.

### Détermination du point de fonctionnement de lecture

Afin de mettre en œuvre ce procédé, il est nécessaire de disposer d'un point de fonctionnement de lecture Pᵢₛₒ associé à un régime isolé pour lequel un passage d'une particule chargée PC du premier sous-système CP,QD1 vers le deuxième sous-système RE,QD2 et vice-versa est interdit pour une durée de référence.

Le point de fonctionnement de lecture Pᵢₛₒ est déjà connu et a été déterminé par un procédé 100 ou tout autre procédé. Il n'est donc pas nécessaire de le déterminer. C'est notamment le cas lorsque, par exemple, les points de fonctionnement associés au chargement d'un état singulet ont été déterminés.

En revanche, lorsque ce dernier n'est pas connu, le procédé 300 comprend tout d'abord une étape 3E1 de détermination du point de fonctionnement de lecture Pᵢₛₒ, ledit point de fonctionnement de lecture Pᵢₛₒ étant déterminé à l'aide d'un procédé 100 la durée de référence étant supérieure ou égale à la durée nécessaire à la détermination de l'état de charge. Le point de fonctionnement de lecture Pᵢₛₒ ainsi sélectionné est celui pour lequel l'optimisation des paramètres du moyen de mesure CS de l'état de charge sera effectuée.

Une fois le point de fonctionnement de lecture Pᵢₛₒ connu, le procédé 300 comprend, à partir de ce point de fonctionnement de lecture Pᵢₛₒ et pour une pluralité de jeux de paramètres de mesure les étapes suivantes.

### Mesure du signal associé à un premier état de charge

Le procédé 300 comprend une étape 3E2 de chargement du premier sous-système CP/QD1 dans un premier état de charge suivie d'une étape 3E3 de mesure du signal du moyen de mesure de l'état de charge associé à ce premier état de charge.

A l'issue de ces deux étapes 3E2,3E3, le signal du moyen de mesure CS de l'état de charge correspondant au premier état de charge pour le jeu de paramètres considérée est connu.

### Mesure du signal associé à un deuxième état de charge différent du premier état de charge

Le procédé 300 comprend ensuite une étape 3E4 de chargement du premier sous-système CP/QD1 dans un deuxième état de charge différent du premier état de charge suivie d'une étape 3E5 de mesure du signal du moyen de mesure CS de l'état de charge associé à ce deuxième état de charge.

A l'issue de ces deux étapes 3E4,3E5, le signal du moyen de mesure CS de l'état de charge correspondant au premier état de charge pour le jeu de paramètres considérée est connu.

### Détermination de la différence entre les deux signaux mesurés

Une fois un signal mesuré pour chaque état de charge, il est possible de mesurer la différence entre ces deux signaux. Pour cela, le procédé 300 comprend une étape 3E6 de soustraction du signal du moyen de mesure SC associé au premier état de charge par le signal du moyen de mesure SC associé au deuxième état de charge de sorte à obtenir la différence entre les deux signaux pour le jeu de paramètre considéré.

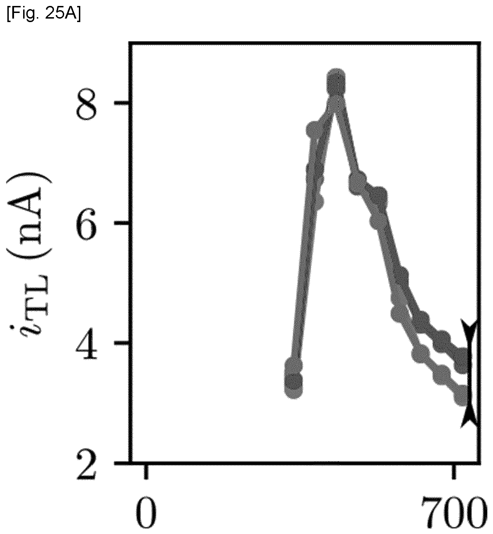

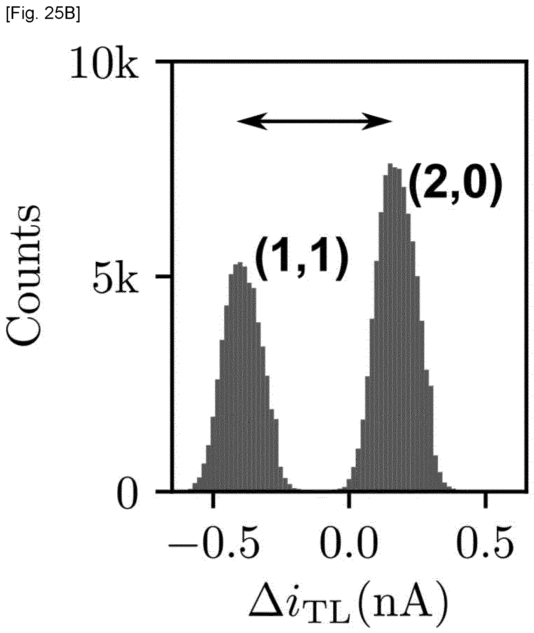

La [Fig. 25A] illustre plusieurs courbes mesurées pour le premier et le deuxième état de charge en fonction d'au moins un paramètre. La différence maximale est matérialisée par les deux flèches noires de part et d'autre de la courbe. La [Fig. 25B] montre la statistique obtenue pour le premier état de charge (ici (1,1)) et le deuxième état de charge (ici (2,2)) pour un jeu de paramètres donné. La différence obtenue (ici en courant) pour ce jeu de paramètres à partir de la statistique est matérialisée schématiquement par la flèche noire dans la partie supérieure du graphique.

### Sélection du jeu de paramètres optimal

Dans le procédé 300 les étapes précédentes 3E2-3E6 sont répétées pour une pluralité de jeux de paramètres du moyen de mesure SC. Il est ainsi possible de déterminer le jeu de paramètres optimal, c'est-à-dire le jeu de paramètres qui permet d'obtenir la différence la plus élevée entre les deux signaux mesurés. Pour cela, le procédé comprend ensuite une étape 3E7 de sélection du jeu de paramètres permettant d'obtenir la différence la plus élevée.

Le jeu de paramètre comprend le point de fonctionnement de lecture Pᵢₛₒ et ces étapes sont répétées pour une pluralité de points de fonctionnement de lecture Pᵢₛₒ, le point de fonctionnement de lecture Pᵢₛₒ permettant d'obtenir la différence la plus élevée étant retenue dans le jeu de paramètres sélectionné.

### Régime partiellement isolé

Le système SYS comprend un couple CP de boites quantiques QD ou une boite quantique QD1 du couple CP de boites quantiques QD correspondant au premier système et un réservoir RE de particules chargées PC correspondant au deuxième sous-système. Le régime isolé associé au point de fonctionnement de lecture Pᵢₛₒ est le régime partiellement isolé.

### Régime totalement isolé

Le système SYS comprend un couple CP de boites quantiques QD comprenant une première boite quantique QD1 et une deuxième boite quantique QD2 ainsi qu'un nombre fixe de particules chargées PC, la première boite quantique QD1 correspondant au premier sous-système et la deuxième boite quantique QD2 correspondant au deuxième sous-système. Le régime isolé associé au point de fonctionnement de lecture Pᵢₛₒ est le régime totalement isolé.

### Procédé de détermination d'un point de fonctionnement de conversion spin/charge optimal

Afin de pouvoir accéder à l'état de spin des particules chargées PC au sein d'un système SYS il est connu d'avoir recours à une étape de conversion spin/charge. Cette conversion se fait généralement à l'aide d'un point de fonctionnement, appelé dans la suite point de fonctionnement de conversion.

Or, comme déjà mentionné dans le cas du point de fonctionnement de lecture, dans l'état de la technique, la position du point de fonctionnement de lecture est souvent liée au point de fonctionnement de conversion spin/charge. Aussi, il est en pratique impossible de caractériser chacun des points de fonctionnement de conversion.

En revanche, en utilisant un régime d'isolement total pour lequel l'état de charge est pratiquement garanti de ne pas changer sur la durée de référence considérée, il est possible d'utiliser le même point de fonctionnement de lecture quel que soit le point de fonctionnement de conversion spin/charge considéré. Il devient alors possible d'optimiser ce point de fonctionnement de conversion spin/charge, par exemple en déterminant le point de fonctionnement de conversion spin/charge permettant d'optimiser la différence du signal mesuré pour deux états de spin différents.

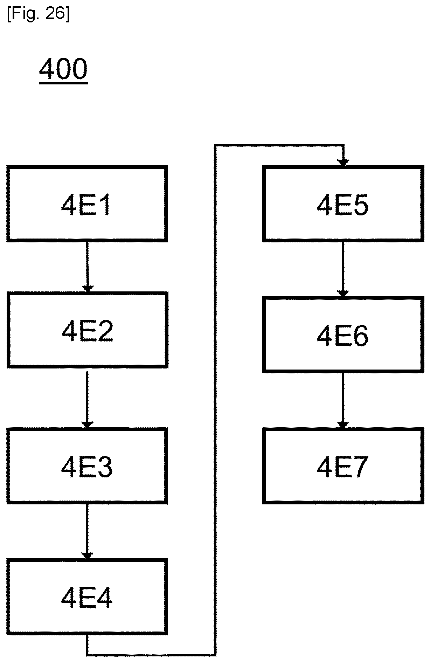

A cette fin, un quatrième aspect illustré à la [Fig. 26] concerne un procédé 400 de détermination d'un point de fonctionnement de conversion spin/charge optimal. Cependant, avant de détailler le procédé 400 en question, il convient de préciser la notion de bases propre dans le cadre du système SYS. Pour rappel, cette notion est bien connue de la personne du métier.

### Bases propres des états de spin de deux particules chargées

Lorsque l'on cherche à caractériser l'état de spin d'un système, il est nécessaire d'avoir recours à une base qu'il est possible de choisir de manière arbitraire. Cependant, pour un point de fonctionnement donné, parmi l'infinité de bases possibles, il est possible d'identifier une base particulière, dite base propre. Les notions de vecteurs propres et de base propre sont des notions bien connues de la personne du domaine et ne seront donc pas détaillées ici.

Dans le système SYS il est possible d'identifier deux bases propres en fonction du régime de fonctionnement et de l'état de charge du couple CP de boites quantiques QD. Lorsque le système SYS est dans le régime totalement isolé et que chaque boite quantique contient une particules chargées (autrement dit chaque particule chargée est dans une boite quantique et les boites quantiques ne sont pas couplées), la base propre permettant de décrire l'état de spin de deux particules chargées est la base (u,d),(d,u),(u,u) et (d,d) où « d » signifie « spin down » et « u » signifie « spin up ». Lorsque les deux particules chargées PC sont dans la même boite quantique QD1,QD2 ou que le système SYS est dans le régime partiellement isolé (autrement dit chaque particule chargée PC est dans une boite quantique QD1,QD2 et les boites quantiques QD1,QD2 sont fortement couplées), la base propre permettant de décrire l'état de spin de deux particules chargées PC est la base S, T-, T0, T+ déjà introduite.

### Initialisation de l'état de spin à l'état singulet

Le procédé 400 selon l'invention comprend une étape 4E1 d'initialisation du système dans l'état de spin singulet S à l'aide d'un point de fonctionnement associé au chargement d'un état singulet dans le couple CP de boites quantiques QD, le point de fonctionnement à l'issue de l'initialisation étant associé à un premier état de charge.

Le point de fonctionnement associé au chargement de deux particules chargées PC dans un état singulet S est connu et peut avoir été déterminé à l'aide d'un procédé 200 selon l'invention ou tout autre procédé.

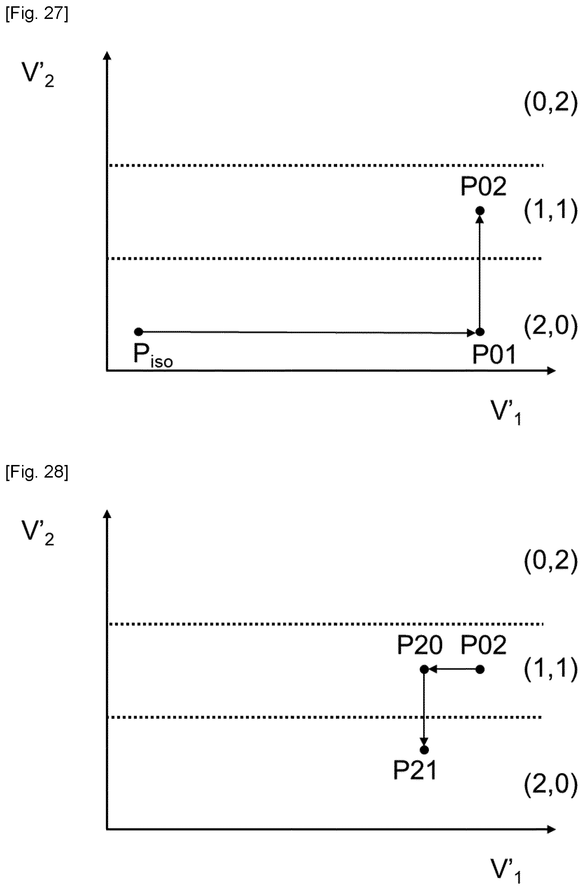

Un exemple de réalisation de cette étape d'initialisation est illustré à la [Fig. 27]. Dans cet exemple, le premier état de charge est l'état de charge (1,1). Cependant, à l'issue du chargement de l'état singulet, le système est dans un deuxième état de charge différent du premier état de charge, ici l'état de charge (2,0). Le trajet illustré à la [Fig. 27] vise donc à passer d'un état de spin singulet et un état de charge (2,0) à un état de spin singulet et un état de charge (1,1).

Dans cet exemple de réalisation, l'initialisation comprend une sous-étape d'augmentation, à partir d'un premier point de fonctionnement Pᵢₛₒ correspondant au régime totalement isolé et à l'état de charge (2,0), du paramètre Γ*_{QD}* relatif à la barrière de potentiel séparant les deux boites quantiques QD1,QD2 de sorte à amener le système dans un deuxième point de fonctionnement P01 correspondant au même état de charge, mais dans lequel les deux boites quantiques QD1,QD2 du couple CP de boites quantiques QD1,QD2 sont couplées. Cette sous-étape est suivie d'une sous-étape de modification, à partir du deuxième point de fonctionnement P01, du paramètre *ε* relative à la différence de potentiel entre les deux boites quantiques QD1,QD2 de sorte à amener le système dans un troisième point de fonctionnement P02 correspondant à l'état de charge (1,1), le changement d'état de charge se faisant de manière adiabatique (par rapport au couplage tunnel entre la première boite quantique QD1 et la deuxième boite quantique QD2 au deuxième pour de fonctionnement P01) lors du déplacement du deuxième point de fonctionnement P01 au troisième point de fonctionnement P02 de sorte à préserver l'état singulet.

Le procédé 400 comprend, avant l'étape 4E1 d'initialisation, une étape de détermination du point de fonctionnement associé au chargement de deux particules chargées dans un état singulet, par exemple à l'aide d'un procédé 200 selon l'invention (mais tout autre procédé peut être utilisé).

### Conversion de l'état singulet et mesure de l'état de charge

Le procédé comprend ensuite une étape 4E2 de conversion spin/charge de l'état de charge du système à l'aide d'un point de fonctionnement de conversion P21 suivie d'une étape 4E3 de mesure du signal mesuré par le moyen de détection de l'état de charge pour l'état de charge ainsi converti.

Poursuivant le même exemple l'étape de conversion spin/charge est illustré à la [Fig. 28]. Dans cet exemple, la conversion spin/charge comprend une sous-étape de modification, à partir du troisième point de fonctionnement P02, du paramètre Γ_{QD} de sorte à atteindre un quatrième point de fonctionnement P20 ayant une valeur du paramètre Γ_{QD} égale à la valeur du paramètre Γ_{QD} du point de fonctionnement de conversion P21, la modification se faisant de manière non-adiabatique comparativement au paramètre Γ_{QD}. Elle comprend ensuite une sous-étape de modification, à partir du quatrième point de fonctionnement P20, du paramètre *ε* de sorte à atteindre le point de fonctionnent de conversion P21, la modification du paramètre *ε* se faisant de manière adiabatique comparativement au paramètre Γ_{QD}. C'est au cours de cette deuxième sous-étape que l'état de charge va être modifié si les particules chargées sont dans le premier état de spin (ici l'état de singulet) et va rester inchangé si les particules chargées PC sont dans le deuxième état de spin (ici un état de spin triplet). Dans un exemple particulier la conversion comprend également une sous-étape d'attente au point de fonctionnement de conversion.

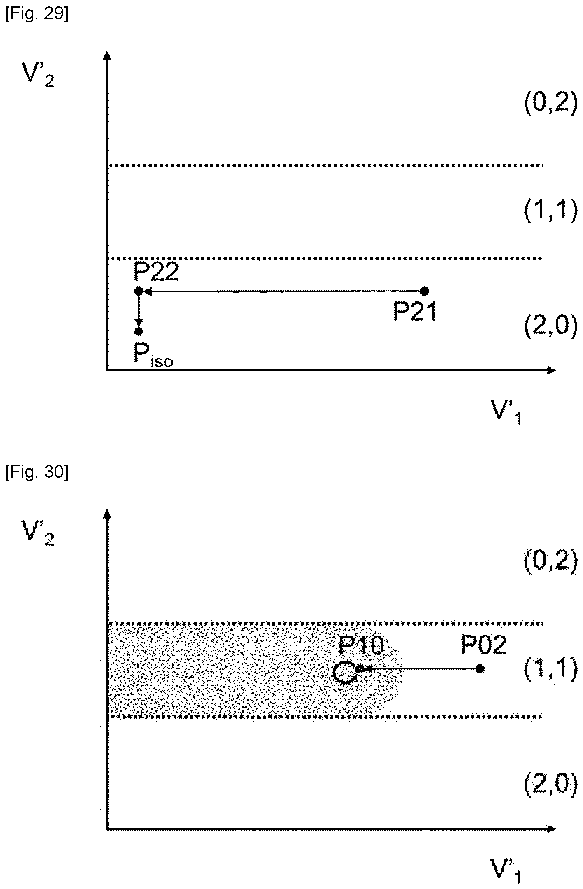

Toujours selon le même exemple l'étape de mesure est illustrée à la [Fig. 29]. Plus particulièrement, la mesure de l'état de charge comprend une sous-étape de modification, à partir du point de fonctionnement P21 de conversion, du paramètre Γ_{QD} de sorte à atteindre un sixième point de fonctionnement P22 ayant une valeur du paramètre Γ_{QD} égale à la valeur du paramètre Γ_{QD} du premier point de fonctionnement P00. Autrement dit, le déplacement se fait le long des lignes de dégénérescence de charge. Cela signifie également que si le point de fonctionnement de conversion P21 est effectivement dans une région de blocage de Pauli, alors ce déplacement se fait dans cette même région et ce jusqu'à la région correspondant au régime d'isolement total, ce qui garantit que l'état de charge mesuré ultérieurement et bien représentatif de l'état de charge (et donc de l'état de spin) tel qu'il était au point de fonctionnement de conversion.

La mesure de l'état de charge comprend également une sous-étape de modification, à partir du sixième point de fonctionnement P21, du paramètre *ε* de sorte à atteindre le premier point de fonctionnement de lecture Pᵢₛₒ (et donc une valeur du paramètre *ε* égale à la valeur du paramètre *ε* du premier point de fonctionnement). Elle comprend enfin une sous-étape de mesure du signal associé à l'état de charge du couple CP de boites quantiques QD.

Ainsi, l'étape de conversion converti l'état de spin singulet en état de charge et l'étape de mesure permet de déterminer le signal associé à l'état de charge et donc à l'état de spin singulet S. Le signal mesuré peut ainsi servir de référence dans l'évaluation du point de fonctionnement de conversion considéré.

### Initialisation du spin dans un mélange statistique

Le procédé comprend ensuite une étape 4E4 d'initialisation du système dans un état de spin pouvant prendre soit l'état singulet soit l'état triplet selon une probabilité fixée, dit état de spin mixte, à l'aide d'un point de fonctionnement associé au chargement d'un état singulet dans un couple CP de boites quantiques QD. Par exemple, la probabilité d'être dans l'état singulet est égale à la probabilité d'être dans l'état triplet (et égale à 50%). Bien entendu, d'autres répartitions des probabilités sont possibles. Une méthode permettant d'obtenir un tel mélange statistique sera présentée dans la suite, mais d'autres méthodes connues de la personne du domaine peuvent être utilisées pour obtenir un tel état de spin mixte.

La différence essentielle avec l'état d'initialisation précédente consiste en l'obtention d'un mélange statistique d'un état de spin singulet S et d'un état de spin triplet. Ce mélange statistique peut par exemple être obtenu par une randomisation de l'état de spin.

Dans le cadre du même exemple que précédemment, comme illustré à la [Fig. 30], cette randomisation est effectuée à partir du troisième point de fonctionnement P02. Ce dernier est situé en dehors du régime isolé et la base propre permettant de décrire l'état de spin des particules chargées PC est constituée des vecteur S, T-, T0 et T+ introduit précédemment. De plus, à ce point de fonctionnement P02, l'état de spin des particules chargées PC est connu et égale à l'état singulet S.

Dans un exemple lorsque l'on s'intéresse à l'état de spin singulet S et à l'état de spin triplet T0, l'initialisation comprend, à partir de ce troisième point de fonctionnement, une étape de modification du paramètre Γ_{QD} de sorte à atteindre un point de fonctionnement de randomisation P10 associé au même état de charge que le troisième point de fonctionnement et associé au régime totalement isolé (zone grisée sur la [Fig. 30]), cette modification se faisant de manière non adiabatique (par rapport à l'écart en énergie au croisement évité de l'état de spin singulet S et de l'état de spin triplet T0). Le point de fonctionnement ainsi obtenu étant dans le régime totalement isolé, la base propre permettant de décrire l'état de spin des particules chargée devient la base (u,u), (d,u), (u,d) et (d,d). Cette transition non adiabatique d'une première base propre vers une deuxième base propre va introduire une oscillation de l'état de spin entre l'état singulet S et l'état triplet T0, cette oscillation ayant une fréquence d'oscillation dite de Rabi et noté *f_{Rabi}.* Pour un système donné, cette fréquence n'est pas connue avec précision, mais il est possible d'en fournir une valeur minimale notée ${f}_{Rabi}^{min}$ et une valeur maximale notée ${f}_{Rabi}^{max}$.

Comme mentionné précédemment, il ne s'agit ici que d'un exemple pour l'état de spin singulet S et à l'état de spin triplet T0, mais peut être adapté sans difficulté au couple état de spin singulet S et à l'état de spin triplet T+ ou au couple l'état de spin singulet S et à l'état de spin triplet T+. Pour mémoire, la fréquence de Rabi associé au couple ST+ dépend du gradient de champ magnétique transverse, alors que la fréquence de Rabi associé au couple ST0 dépend du gradient de champ magnétique longitudinal.

Toujours dans le même exemple, afin d'obtenir un mélange statistique des états singulet S et triplet T0 sur un grand nombre d'itérations de l'étape d'initialisation, dans cet exemple de réalisation, cette dernière comprend une sous-étape d'attente au point de fonctionnement de randomisation P10 pendant une durée choisie aléatoirement dans l'intervalle $\left[\frac{1}{{f}_{Rabi}^{max}}, \frac{1}{{f}_{Rabi}^{min}}\right]$. A l'issue de ce temps d'attente, une sous-étape de modification du paramètre Γ_{QD} est mise en œuvre de sorte à atteindre le quatrième point de fonctionnement. Comme mentionné précédemment, les deux paragraphes précédents n'illustrent que l'exemple relatif aux états de spin singulet S et triplet T0, mais cet exemple peut être adapté sans difficulté au couple état de spin singulet S et à l'état de spin triplet T+ ou au couple l'état de spin singulet S et à l'état de spin triplet T+.

### Conversion de l'état mixte et mesure de l'état de charge

Le procédé 400 comprend ensuite une étape 4E5 de conversion spin/charge de l'état de charge du système à l'aide du point de fonctionnement de conversion P21 de sorte à obtenir un état de charge mixte suivie d'une étape 4E6 de mesure du signal mesuré par le moyen de détection de l'état de charge pour l'état de charge mixte ainsi convertie. L'étape de conversion converti ainsi l'état de spin mixte en état de charge mixte et l'étape de mesure permet de déterminer le signal associé à l'état de charge mixte et donc à l'état de spin mixte. Bien entendu, la notion de mixte n'apparait que de manière statistique et résulte d'un grand nombre de mesures dans lequel les deux particules chargées PC sont soit dans l'état singulet, soit dans l'état triplet, cette répartition se faisant selon la loi de probabilité connue évoquée précédemment.

Pour rester dans le même exemple, les sous-étapes de conversion et de mesure sont identiques à celles mises en œuvre dans le cadre du chargement adiabatique.

### Détermination de la différence

Le procédé 400 comprend ensuite une étape 4E7 de détermination de la différence entre le signal mesuré pour l'état de charge associé à l'état de spin singulet et le signal mesuré pour l'état de charge associé à l'état de spin mixte. Autrement dit, durant cette étape, la différence entre un état singulet et un état mixte est déterminée, cette différence mesurant indirectement la différence entre le signal mesuré pour un état singulet et le signal mesuré pour un état triplet.

### Mesure dans l'état totalement isolé

Comme indiqué précédemment, dans le procédé 400 les deux étapes 4E3,4E6 de mesure sont effectuées à un point de fonctionnement associé au régime totalement isolé Pᵢₛₒ dans lequel, pour la durée de référence, aucun échange de particules chargées PC n'est possible entre la première boite quantique QD1 et la deuxième boite quantique QD2. De plus, la durée de référence est choisie supérieure ou égale au temps nécessaire à la mise en œuvre de l'étape (4E3,4E6) de mesure.

Le point de fonctionnement de lecture Pᵢₛₒ est déjà connu et a été déterminé par un procédé 100 selon l'invention ou tout autre procédé.

En revanche, lorsque ce dernier n'est pas connu, le procédé 400 comprend tout d'abord une étape de détermination d'un point de fonctionnement correspondant à un régime isolé du système SYS, dit point de fonctionnement de lecture Pᵢₛₒ, ledit point de fonctionnement de lecture Pᵢₛₒ étant déterminé à l'aide d'un procédé 100 pour la durée de référence considérée.

### Réalisation d'une statistique pour plusieurs points de fonctionnement de conversion et détermination du point de fonctionnement de conversion optimal

De plus, dans le procédé 400 les étapes précédentes 4E1-4E7 sont répétées une pluralité de fois pour chaque pluralité de point de fonctionnement de sorte à établir une différence entre le signal associé à l'état singulet et le signal associé à l'état mixte, le point de fonctionnement de conversion P21 permettant d'obtenir la différence la plus élevée étant considéré comme point de conversion optimal P21. C'est cette statistique qui permet d'obtenir un état de spin mixte (singulet S et T0) à comparer avec un état de spin singulet de sorte à déterminer le point de fonctionnement de conversion P21 permettant d'obtenir la différence la plus élevée.

### Procédé de détermination d'un point de fonctionnement associé au chargement optimal d'un état singulet dans un couple de boites quantiques

Une fois qu'un point de fonctionnement de conversion spin/charge optimal a été déterminée, il peut être avantageux de se servir de ce dernier pour affiner la position des points de fonctionnement associé au chargement de deux particules chargées PC dans un état de spin singulet dans le couple CP de boites quantiques QD.

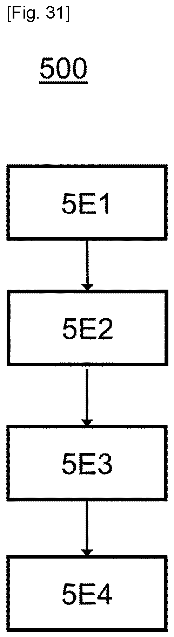

Pour cela, un cinquième aspect illustré à la [Fig. 31] concerne un procédé 500 de détermination d'un point de fonctionnement associé au chargement optimal de deux particules chargées PC dans un état singulet dans un couple de boites quantiques à partir d'un point de fonctionnement de lecture Pᵢₛₒ associé à un régime partiellement isolé dans lequel, pour une première durée de référence, aucun échange de particules chargées PC n'est possible entre le couple CP de boites quantiques QD et le réservoir RE de particules chargées PC.

### Détermination d'une pluralité de points de fonctionnement associé au chargement d'un état singulet

Le procédé 500 visant à optimiser les points de fonctionnement de chargement d'un état singulet déterminés précédemment, ce dernier comprend une étape 5E1 de détermination d'une pluralité de points de fonctionnement associé au chargement d'un état singulet S dans le couple CP de boites quantiques QD, par exemple à l'aide d'un procédé 200 selon un deuxième aspect de l'invention (mais tout autre procédé peut être utilisé).

### Chargement adiabatique

Le procédé 500 comprend ensuite, pour chaque point de fonctionnement de chargement de l'état singulet ainsi déterminé une étape 5E2 de chargement adiabatique du couple de boite quantique à l'aide du point de fonctionnement considéré. Cette étape 5E2 de chargement adiabatique est réalisée de la même manière que le chargement adiabatique décrit précédemment et illustré à la [Fig. 19].

### Conversion spin/charge

Le procédé comprend ensuite une étape 5E3 de conversion spin/charge de l'état de spin des particules chargées PC dans le couple CP de boites quantiques QD à l'aide d'un point de fonctionnement de conversion spin/charge.

Le point de fonctionnement de conversion spin/charge peut être connue par avance.

Lorsque ce point de fonctionnement de conversion spin/charge n'est pas connue, le procédé 500 comprend une étape de détermination d'un point de fonctionnement de conversion spin/charge à l'aide d'un procédé 400 selon un troisième aspect de l'invention. Bien entendu, ce point de fonctionnement de conversion spin/charge pourra également être déterminé par d'autres méthodes.

### Détermination de l'état de charge

Le procédé 500 comprend ensuite une étape 5E4 de détermination de l'état de charge du couple CP de boites quantiques QD. Cette étape 5E4 ayant été précédée d'une conversion spin/charge, cette détermination de l'état de charge permet d'accéder à l'état de spin des particules chargées. De plus, cette détermination de l'état de charge se fait dans un régime totalement isolé dans lequel, pour une deuxième durée de référence, aucun échange de particules chargées PC n'est possible entre les boites quantiques QD1,QD2 du couple CP de boites quantiques QD.

### Réalisation d'une statistique

Afin de réaliser, pour chaque point de fonctionnement, une statistique de l'état de spin mesuré, les trois étapes 5E2-5E4 précédentes sont répétées une pluralité de fois pour chaque point de fonctionnement de chargement. Par ailleurs, la première durée de référence est supérieure ou égale au temps nécessaire à la mise en œuvre de l'étape de conversion spin/charge et de l'étape de détermination de l'état de charge, et la deuxième durée de référence est supérieure ou égale au temps nécessaire à la détermination de l'état de charge du couple CP de boites quantiques QD. De plus, les points de fonctionnement permettant d'obtenir une probabilité de charger un état singlet supérieure à une probabilité seuil sont considérés comme point de fonctionnement de chargement optimal de deux particules chargées PC dans un état singulet. Dans un exemple de réalisation, les points de fonctionnement retenus sont les points de fonctionnement pour lesquels la probabilité de chargé un état de spin singulet S est supérieure ou égale à 0.9, de préférence 0.99, voire 0.9999.

### Résultats

Le procédé selon un cinquième aspect de l'invention permet d'affiner la position des points de fonctionnement associés au chargement d'un état de spin singulet.

### Procédé de détermination de la période d'oscillation entre un premier état de spin et un deuxième état de spin

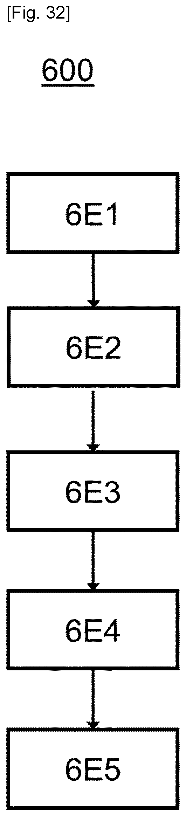

Comme cela vient d'être montré, sous certaines conditions, il est possible d'induire une rotation cohérente entre un premier état de spin et un deuxième état de spin de deux particules chargées. La détermination de la fréquence d'une telle rotation permet de déterminer des paramètres du système SYS tel que le gradient dBz ou le gradient dBx. Il est donc intéressant d'induire une telle rotation puis de caractériser les paramètres qui y sont reliés. Pour cela, un cinquième aspect illustré à la [Fig. 32] concerne un procédé 600 de détermination de la période d'oscillation entre un premier état de spin et un deuxième état de spin de deux particules chargées PC contenues dans le couple CP de boites quantiques QD.

### Etape d'initialisation du système

Le procédé 600 comprend une étape 6E1 d'initialisation du système SYS dans un premier point de fonctionnement pour lequel la première base est une base propre des états de spin des deux particules chargées PC.

### Caractérisation des oscillations S-T0 ou S-T+

Le premier état de spin est l'état singulet et le deuxième état de spin est l'état triplet T0. De manière alternative, le premier état de spin est l'état singulet et le deuxième état de spin est l'état triplet T+.

Dans un exemple pour ces deux modes l'étape 6E1 d'initialisation est identique à celle présenté dans le cadre du procédé 400 de détermination d'un point de fonctionnement de conversion spin/charge optimal et illustré à la [Fig. 27]. A l'issue de cette étape, le système est dans l'état de spin singulet S et dans l'état de charge (1,1).

### Etat de modification non adiabatique du point de fonctionnement

Le procédé 600 comprend ensuite, à partir du premier point de fonctionnement, une étape 6E2 de modification du point de fonctionnement de sorte à atteindre un deuxième point de fonctionnement pour lequel la deuxième base est une base propre des états de spin. Du fait du changement de base propre lors de cette transition non adiabatique (par rapport à l'écart en énergie au croisement évité entre l'état de spin singulet et l'état de spin triplet T0 au deuxième point de fonctionnement), une mise en rotation de l'état de spin a lieu entre le premier état de spin et le deuxième état de spin.

### Caractérisation des oscillations S-T0

Lorsque les oscillations à caractériser sont les oscillations S-T0, comme déjà présenté dans le cadre du procédé 400 de détermination d'un point de fonctionnement de conversion spin/charge, cette étape 6E2 peut être mise en œuvre en modifiant le point de fonctionnement de manière non adiabatique (par rapport à l'écart en énergie au croisement évité entre l'état de spin singulet et l'état de spin triplet T0 au deuxième point de fonctionnement) de sorte à obtenir un deuxième point de fonctionnement dans le régime isolé. Une telle modification est illustrée à la [Fig. 31].

### Caractérisation des oscillations S-T+

Lorsque les oscillations à caractériser sont les oscillations S-T+, cette étape 6E2 peut être mise en œuvre en modifiant le point de fonctionnement de manière non-adiabatique (par rapport à l'écart en énergie au croisement évité entre l'état de spin singulet S et l'état de spin triplet T+) de sorte à obtenir un deuxième point de fonctionnement situé au niveau d'un zone appelé évitement (ou croisement évité) S-T+ (ou S-T+ anti-crossing en anglais) est bien connue de la personne du domaine.

### Rotation cohérente pendant un temps prédéterminé

Le procédé 600 comprend ensuite une étape 6E3 d'attente pendant un temps prédéterminé au deuxième point de fonctionnement durant laquelle la rotation entre le premier état de spin et le deuxième état de spin se poursuit de manière cohérente.

### Conversion spin/charge

Le procédé 600 comprend ensuite une étape 6E4 de conversion spin/charge de l'état de spin des deux particules chargées PC, la conversion se faisant à l'aide d'un point de fonctionnement de conversion et permettant d'associer au premier état de spin un premier état de charge et au deuxième état de spin un deuxième état de charge différent du premier état de charge. On notera que le même point de fonctionnement de conversion peut être utilisé pour les oscillations S-T0 et les oscillations S-T+.

Ce point de fonctionnement de conversion est déterminé à l'aide d'un procédé 400. Bien entendu, d'autres méthodes peuvent être utilisées pour déterminer ce point de fonctionnement de conversion.

### Caractérisation des oscillations S-T0 ou S-T+

Que cela soit pour caractériser l'oscillation S-T0 ou l'oscillation S-T+, la conversion se fait de manière identique. Elle comprend une sous-étape de modification, à partir du deuxième point de fonctionnement P10, du paramètre Γ_{QD} de sorte à atteindre un quatrième point de fonctionnement P20 ayant une valeur du paramètre Γ_{QD} égale à la valeur du paramètre Γ_{QD} du point de fonctionnement de conversion P21, la modification se faisant de manière non-adiabatique (par rapport à l'écart en énergie au croisement évité entre l'état de spin singulet S et l'état de spin triplet T0 ou l'état de spin triplet T+). Elle comprend ensuite une sous-étape de modification, à partir du quatrième point de fonctionnement P20, du paramètre *ε* de sorte à atteindre le point de fonctionnent de conversion P21, la modification du paramètre *ε* se faisant de manière adiabatique comparativement au paramètre Γ_{QD}.

### Détermination de l'état de charge

Le procédé 600 comprend également une étape 6E5 de détermination de l'état de charge du couple de boite quantique, la détermination se faisant en un point de fonctionnement de lecture associé à un régime totalement isolé dans lequel aucun échange de particule chargée PC n'est possible entre la première boite quantique QD1 et la deuxième boite quantique QD2 du couple CP de boite quantique QD.

### Caractérisation des oscillations S-T0 ou S-T+

Que cela soit pour caractériser l'oscillation S-T0 ou l'oscillation S-T+, la détermination de l'état de charge se fait de manière identique et illustré à la [Fig. 29].

### Réalisation d'une statistique pour plusieurs temps d'attente

Dans le procédé 600 les cinq étapes 6E1-6E5 précédentes sont répétées pour une pluralité de temps d'attente et une pluralité de fois pour chaque temps d'attente de sorte à déterminer l'évolution temporelle du premier état de spin ou du deuxième état de spin.

### Détermination de la position de l'évitement S-T+

Comme mentionné précédemment, afin de déterminer la fréquence d'oscillation S-T+, il est nécessaire de connaitre la position des points de fonctionnement du système pouvant être associé à l'évitement S-T+. La détermination de ces points de fonctionnement est connue de la personne du domaine, mais une méthode permettant de déterminer cette position va maintenant être décrite à titre d'illustration.

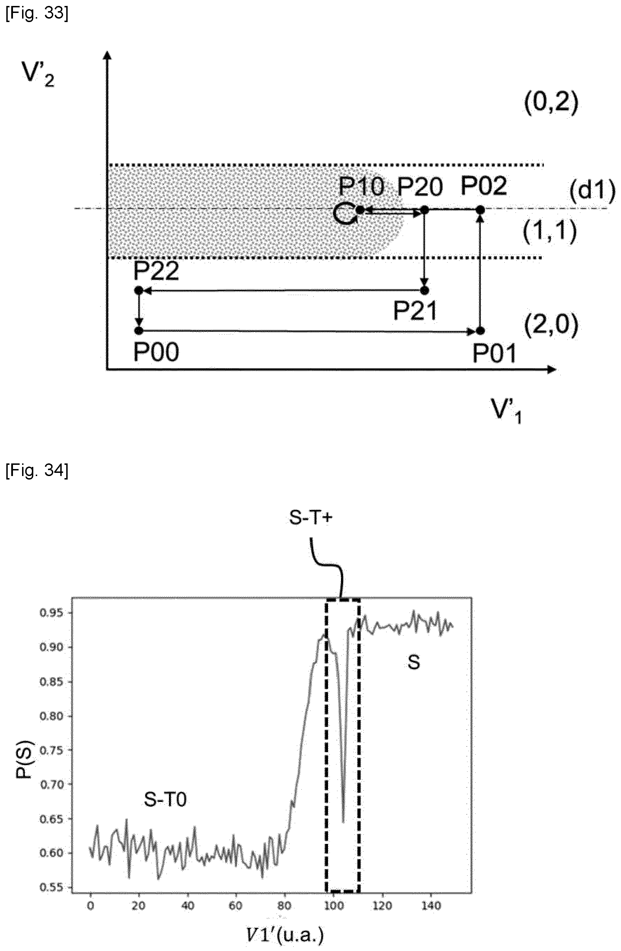

La séquence utilisée est identique à celle mise en œuvre lors de la détermination d'un point de fonctionnement de conversion optimal. Lors de cette détermination, la séquence reprise à la [Fig. 33] est mise en œuvre de sorte à obtenir un état de spin mixte, c'est-à-dire un état pour lequel au moins deux états de spin différents ont une probabilité non nulle d'être mesurée. Pour tout point de fonctionnement P10, il est donc possible de déterminer la probabilité de mesurer un état singulet (à l'aide d'une conversion spin/charge suivie d'une mesure de l'état de charge comme détaillé auparavant). En mesurant cette probabilité (notées P(S)) pour une pluralité de point de fonctionnement P10 située sur un axe d1, la courbe illustrée à la [Fig. 34] est obtenue. Sur cette courbe, il est possible d'identifier une première zone pour laquelle la probabilité de mesuré un état de spin singulet est approximativement égale à ½ (notée S+T0) et une deuxième zone dans laquelle la probabilité de mesuré un état de spin singulet est approximativement de 1 (notée S). En outre, dans cette deuxième zone, un pic étroit apparait pour lequel la probabilité de mesuré un état singulet chute à ½ (noté S-T+). La position de l'évitement S-T+ est donné par la position de ce pic.

On notera par ailleurs que si cette opération est effectuée pour une pluralité de champ magnétique statique, alors il est possible de déduire, à partir de l'évolution de la position du pic associé à l'évitement S-T+, le facteur de conversion entre la tension appliquée sur les grilles et l'énergie associé à la barrière tunnel Γ*_{QD}*. Il sera également détaillé dans la suite comment il est possible d'accéder au facteur de conversion entre la tension appliquée sur les grilles et l'écart en énergie du niveau fondamental *ε.*

Bien entendu, il ne s'agit là que d'un exemple et d'autres méthodes peuvent être utilisée pour déterminer les points de fonctionnement associés à cet évitement S-T+.

### Résultats

A l'issue du procédé selon un sixième aspect de l'invention, la fréquence de Rabi associé à l'oscillation entre le premier état de spin et le deuxième état de spin est connue.

### Procédé de caractérisation de l'interaction d'échange entre deux particules chargées

La finalité d'un système SYS est de mettre en œuvre des portes quantiques afin de réaliser une ou plusieurs opérations quantiques. Aussi, il peut être avantageux d'identifier les points de fonctionnements permettant de réaliser une porte quantique à un ou deux qubits, c'est-à-dire impliquant une ou deux particules chargées PC. Autrement dit, il est utile de caractériser l'interaction d'échange entre deux particules chargées afin de pouvoir contrôler la valeur de cette dernière.

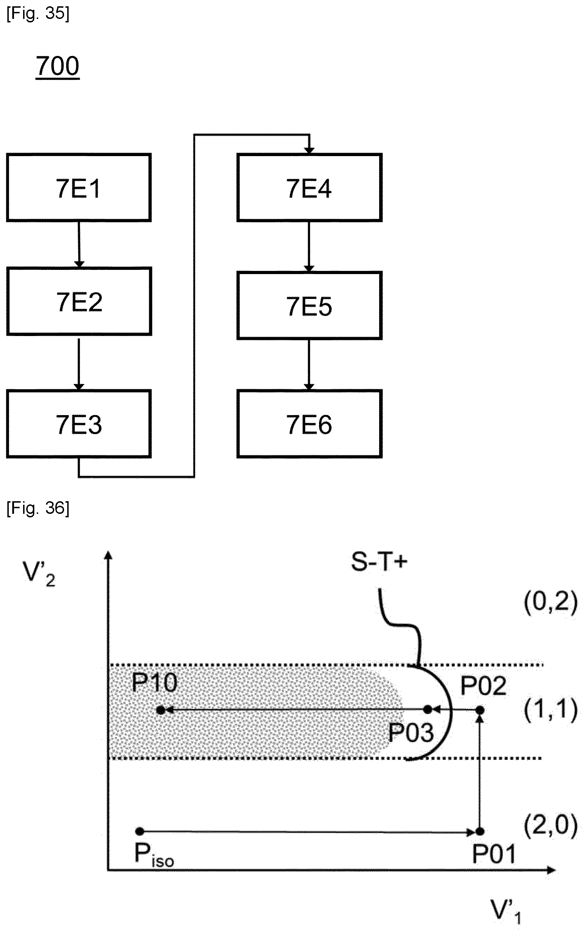

Pour cela, un sixième aspect de l'invention illustré à la [Fig. 35] concerne un procédé 700 de caractérisation de l'interaction d'échange entre deux particules chargées dans un couple CP de boites quantiques QD d'un système SYS chaque boite quantique QD1,QD2 contenant une particule chargée PC. Autrement dit, il s'agit de caractériser l'interaction d'échange entre deux particules chargées PC dans le couple CP de boite quantique QD lorsque l'état de charge du couple CP de boites quantiques QD est (1,1). Le procédé 700 comprend, pour une pluralité de points de fonctionnement à caractériser, les étapes suivantes.

### Initialisation du système

Le procédé comprend tout d'abord une étape 7E1 d'initialisation du système dans un point de fonctionnement initial P10 associé à un état de charge (1,1), un régime totalement isolé et pour lequel l'état de spin est l'état de spin (u,d).

Cette initialisation peut comprendre une sous-étape de chargement de deux particules chargées PC dans l'état singulet S. Un tel chargement peut par exemple être fait en utilisant un point de fonctionnement de chargement déterminé par un procédé 200. Cependant, toute méthode permettant de charger deux particules chargées PC dans l'état singulet S peut être utilisée.

Dans un exemple de réalisation illustré à la [Fig. 36], le système SYS est chargée dans un état de spin singulet S et un état de charge (2,0) dans un point de fonctionnement de lecture Pᵢₛₒ associé au régime totalement isolé. Un tel point de fonctionnement pourra par exemple être déterminé à l'aide d'un procédé 100. Bien entendu, d'autres méthodes peuvent également être utilisées pour déterminer la position de ce point de fonctionnement. Le point de fonctionnement est ensuite modifié de manière identique à la séquence de la [Fig. 27] déjà décrite pour arriver à un troisième point de fonctionnement P02 en passant par un deuxième point de fonctionnement P01, cette modification se faisant de manière adiabatique (par rapport au couplage tunnel entre les deux boites quantiques QD au troisième point de fonctionnement).

A partir du troisième point de fonctionnement P02, l'initialisation comprend une sous-étape de modification non adiabatique (par rapport à l'écart en énergie le plus faible entre l'état de spin S et l'état de spin T+, obtenu au niveau du croisement des deux niveaux) du paramètre Γ_{QD} de sorte à traverser la zone de croisement S-T+ et atteindre un point de fonctionnement P03. L'initialisation comprend ensuite une sous-étape de modification adiabatique (par rapport à l'écart en énergie le plus faible entre l'état de spin S et l'état de spin T0, obtenu au niveau du croisement des deux niveaux) du paramètre Γ_{QD} de sorte à atteindre le point de fonctionnement initial P10 associé au même état de charge que le troisième point de fonctionnement et associé au régime totalement isolé, cette modification se faisant de manière adiabatique (il n'y a donc pas de mise en rotation des états de spin comme dans lors de la randomisation des états de spin). Cette première sous-étape permet de passer de l'état de spin T+ à un état de spin « produit ud ». Plus particulièrement, la première sous-étape consiste à passer d'un point de fonctionnement pour lequel l'état de spin est l'état de spin singulet S et est dans l'état fondamental à un point de fonctionnement pour lequel l'état de spin reste l'état de spin singulet S, mais pour lequel l'état fondamental est l'état de spin triplet T+ (après le passage du croisement ST+). De plus, la deuxième sous-étape consiste à convertir l'état de spin singulet S en « produit ud » avec la modification adiabatique du point de fonctionnement.

### Modification non adiabatique du point de fonctionnement

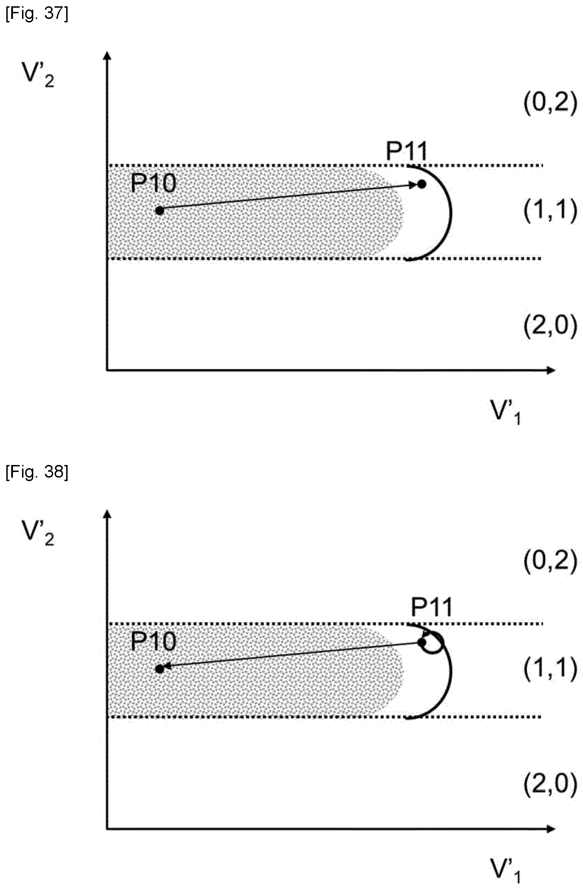

Comme illustré à la [Fig. 37], le procédé 700 comprend, à partir du point de fonctionnement initial P10, une étape 7E1 de modification non adiabatique (par rapport à l'écart en énergie au croisement évité entre l'état de spin singulet S et l'état de spin triplet T0 ou l'état de spin triplet T+) du point de fonctionnement de sorte à obtenir un point de fonctionnement à caractériser. De préférence, le point de fonctionnement à caractériser est associé à un état de charge (1,1) (autrement dit, un état de charge identique à l'état de charge du point de fonctionnement à caractériser). En effet, l'analyse des points de fonctionnement associés à un état de charge (2,0) ou (0,2) présente en général peu d'intérêt pour la mise en œuvre d'une porte quantique.

### Attente au point de fonctionnement à caractériser

Comme illustré à la [Fig. 38], le procédé 700 ensuite une étape 7E2 d'attente au point de fonctionnement à caractériser durant une durée prédéterminée. Ce temps d'attente correspondant à la durée cible de la porte quantique pour laquelle on cherche à caractériser l'interaction d'échange. Cette étape 7E2 est suivie d'une étape 7E3 de modification du point de fonctionnement de sorte à revenir au premier point de fonctionnement, cette modification étant effectuée de manière non-adiabatique (par rapport à l'écart en énergie au croisement évité entre l'état de spin singulet S et l'état de spin triplet T0 ou l'état de spin triplet T+).

### Conversion spin/charge

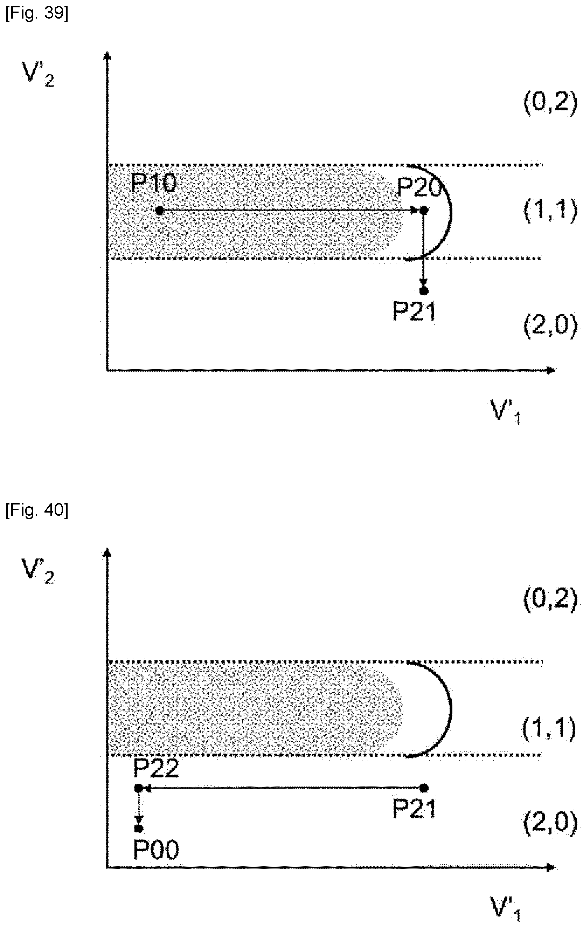

Comme illustré à la [Fig. 39], le procédé 700 comprend également, à partir du point de fonctionnement initial, une étape 7E4 de conversion spin/charge à l'aide d'un point de fonctionnement de conversion. Dans l'exemple de la [Fig. 39], cette conversion comprend une sous-étape de modification, à partir du point de fonctionnement initial P10, du paramètre Γ_{QD} de sorte à atteindre un point de fonctionnement P20 ayant une valeur du paramètre Γ_{QD} égale à la valeur du paramètre Γ_{QD} du point de fonctionnement de conversion P21, la modification se faisant de manière adiabatique (par rapport à l'écart en énergie au croisement évité entre l'état de spin singulet S et l'état de spin triplet T0). Lors de cette première sous-étape, une conversion de base s'opère de la base (u,d) vers la base (S,T) et au point de fonctionnement P20 obtenu, dit point de conversion de base, l'état de spin des deux particules chargées (PC) est un état de spin singlet ou un état de spin triplet Elle comprend ensuite une sous-étape de modification, à partir du point de fonctionnement P20, du paramètre *ε* de sorte à atteindre le point de fonctionnent de conversion P21, la modification du paramètre *ε* se faisant de manière adiabatique comparativement au paramètre Γ_{QD} au point de fonctionnement P20.

Le point de fonctionnement de conversion est un point de fonctionnement de conversion connue, par exemple déterminé à l'aide d'un procédé 400 selon l'invention ou tout autre procédé.

Le point de fonctionnement de conversion est un point de fonctionnement de conversion optimal et le procédé 700 comprend donc au préalable, une étape de détermination d'un point de fonctionnement de conversion optimal à l'aide d'un procédé 400. Bien entendu, il est également possible de déterminer un tel point de fonctionnement à l'aide d'autres méthodes.

### Détermination de l'état de charge

Comme illustré à la [Fig. 40], le procédé 700 comprend également une étape 7E5 de détermination de l'état de charge à l'aide du point de fonctionnement de lecture Pᵢₛₒ dans le régime totalement isolé. Cette étape 7E5 ayant été précédée d'une étape 7E4 de conversion, la mesure de l'état de charge permet de déterminer l'état de spin des particules chargées.

### Caractérisation d'une pluralité de points de fonctionnement de sorte à déterminer une zone optimale

Les étapes précédentes sont répétées une pluralité de fois pour chaque point de fonctionnement à caractériser de sorte à déterminer, pour chaque d'eux, la probabilité de mesurer l'état de spin dans un état singulet S et ainsi caractériser l'interaction d'échange.

Une fois cette interaction d'échange caractérisé, il sera ensuite possible de déterminé au moins une zone, dite zone optimale, dans laquelle le point de fonctionnement pour lequel l'interaction d'échange prend la valeur souhaitée.

### Cartographie de la probabilité

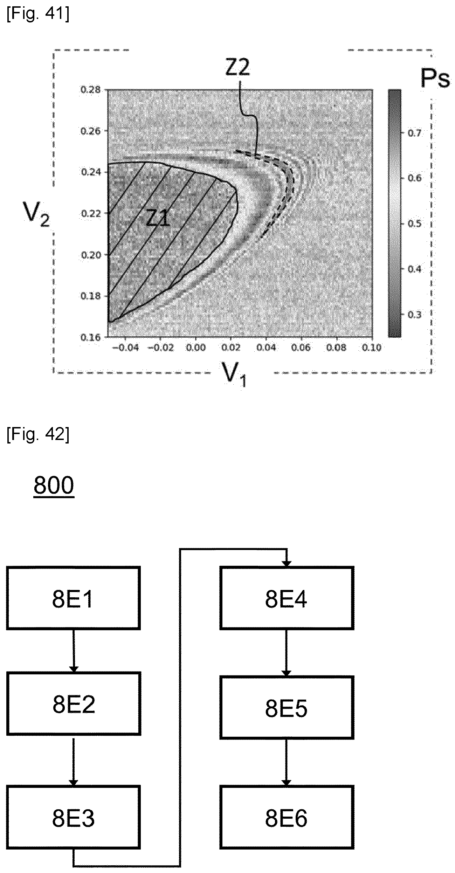

La probabilité de mesurer un état de spin singulet S évoquée précédemment peut être représentée dans le diagramme de stabilité comme illustré à la [Fig. 41] (dans cette figure, les cross-talk n'ont pas été corrigés, ce qui explique l'inclinaison des motifs). Comme mentionné dans le paragraphe précédent, il est possible, à partir de cette probabilité, d'identifier la valeur de l'interaction d'échange pour chaque point de fonctionnement à caractérisé. Or, cette valeur permet de déterminer la porte quantique réalisée au point de fonctionnement considérée. Il est donc possible, comme mentionné précédemment, de déterminée la zone dans lequel va se située le point de fonctionnement optimal pour une porte quantique donnée en fonction de la probabilité de mesuré un état de spin dans l'état singulet S. Par exemple, si l'on souhaite mettre en œuvre une porte à un qubit, le point de fonctionnement choisi devra être associé à une forte probabilité de mesurer l'état singulet, c'est-à-dire se trouver dans la zone Z1. Inversement, si l'on souhaite mettre en œuvre une porte à deux qubit, le point de fonctionnement choisi devra être associé à une phase de pi, c'est-à-dire se trouver dans la zone Z2. Il est donc possible de déterminer une pluralité de zones optimales, chaque zone étant associé à une porte quantique donnée.

### Détermination du point de fonctionnement optimal

Le procédé comprend ensuite, pour chaque point de fonctionnement située dans la zone optimale, une étape 7E6 comprenant une pluralité de mise en œuvre de la porte quantique cible, le point de fonctionnement permettant d'obtenir la meilleure fidélité étant choisi comme point de fonctionnement optimal, par exemple le point de fonctionnement présentant un point de symétrie où il y a le plus d'oscillations.

### Résultats

A l'issue de ce procédé, l'interaction d'échange pour une porte quantique donnée a été caractériser permettant ainsi de déterminer un point de fonctionnement adaptée à la porte quantique considéré.

### Procédé de détermination du facteur de conversion entre la tension appliquée aux grilles du système et le couplage tunnel entre les deux boites quantiques

Lors de l'utilisation d'un système SYS il peut être intéressant de déterminer le facteur de conversion entre la tension appliquée sur les grilles et couplage tunnel Γ*_{QD}*. Il a été montré précédemment que ce facteur pouvait être déterminé à partir de l'évolution de la position de l'évitement S-T+ en fonction du champ magnétique.

Il est cependant possible de déterminer cette valeur à l'aide d'une deuxième méthode qui va maintenant être décrite. Pour cela, un huitième aspect de l'invention concerne un procédé 800 de détermination du facteur de conversion entre une tension appliquée aux grilles d'un système SYS et le couplage tunnel Γ*_{QD}* entre les deux boites quantiques QD1,QD2 du couple CP de boites quantiques QD, le système SYS comprenant un couple CP de boites quantiques QD contenant deux particules chargées PC et comportant une première boite quantique QD1 et une deuxième boite quantique (QD2), et le couplage tunnel Γ*_{QD}* entre les deux boites quantiques QD1,QD2 du couple CP de boites quantiques QD étant modulée à l'aide d'une pluralité de grilles, un jeu de tensions appliqués sur lesdites grilles de la pluralité de grilles définissant un point de fonctionnement du système SYS, le couple CP de boites quantiques QD étant dans un état de charge parmi l'état de charge (2,0), l'état de charge (1,1) et l'état de charge (0,2), et les deux particules chargées PC adoptant soit un état de spin singulet S soit un état de spin triplet T+.

### Initialisation du système

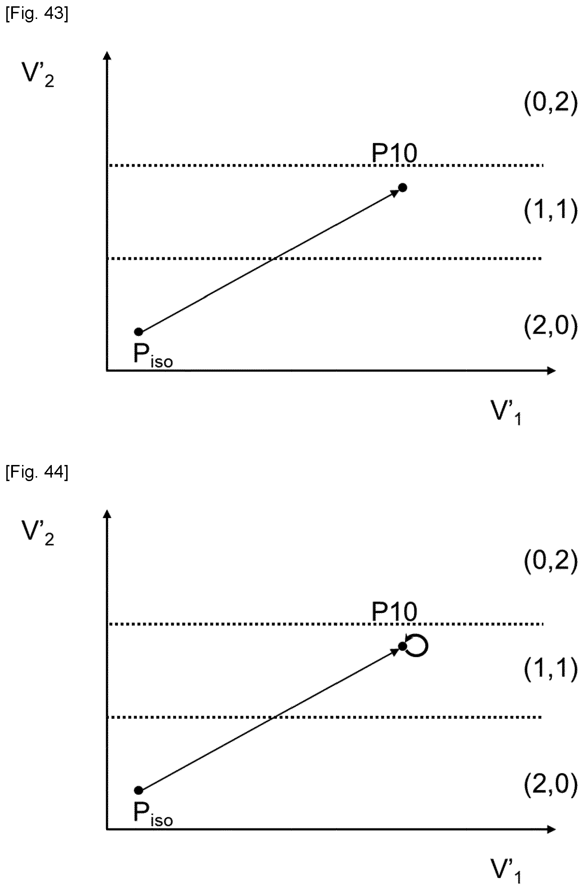

Comme illustré à la [Fig. 43], le procédé 800 comprend une étape 8E1 d'initialisation du système dans un point de fonctionnement de lecture associé au régime totalement isolé et à l'état de charge (2,0) et dans un état de spin singulet S.

La position du point de fonctionnement de lecture Pᵢₛₒ est connue.

La position du point de fonctionnement de lecture Pᵢₛₒ n'est pas connue et le procédé selon l'invention comprend au préalable une étape de détermination d'un point de fonctionnement dans le régime totalement isolé à l'aide d'un procédé 100 selon l'invention.

L'initialisation du système dans l'état de spin singulet est réalisée à l'aide d'un point de fonctionnement de chargement associé à l'état singulet déterminé à l'aide d'un procédé 200 et le procédé comprend donc, au préalable, une étape de détermination d'un point de fonctionnement.

### Modification non adiabatique

Le procédé 800 comprend ensuite une étape 8E2 de modification du point de fonctionnement de sorte à atteindre un point de fonctionnement P10 à caractériser, ladite modification étant effectuée de manière non adiabatique (par rapport à l'écart en énergie au niveau du croisement évité entre l'état de spin singulet S et l'état de spin T+). Cette modification non-adiabatique va avoir pour conséquence d'induire une oscillation cohérente de l'état de spin entre l'état de spin singulet S et l'état de spin triplet T+.

De préférence, le point de fonctionnement à caractérisé est associé à l'état de charge (1,1), l'exploration des points de fonctionnement associé à l'état de charge (2,0) ou (0,2) ne présentant en général que peu d'intérêt.

### Attente au point de fonctionnement à caractériser.

Comme illustré à la [Fig. 44], le procédé comprend ensuite une étape 8E3 d'attente au point de fonctionnement à caractériser durant une durée choisie aléatoirement dans l'intervalle $\left[\frac{1}{{f}_{Rabi}^{max}}, \frac{1}{{f}_{Rabi}^{min}}\right]$ de sorte à laisser librement l'état de spin osciller de manière cohérente. Pour rappel, ${f}_{Rabi}^{max}$ est la vitesse maximale d'oscillation entre l'état de spin singulet S et l'état de spin triplet T+ et ${f}_{Rabi}^{min}$ est la vitesse minimale d'oscillation entre l'état de spin singulet S et l'état de spin triplet T+.

### Conversion spin-charge

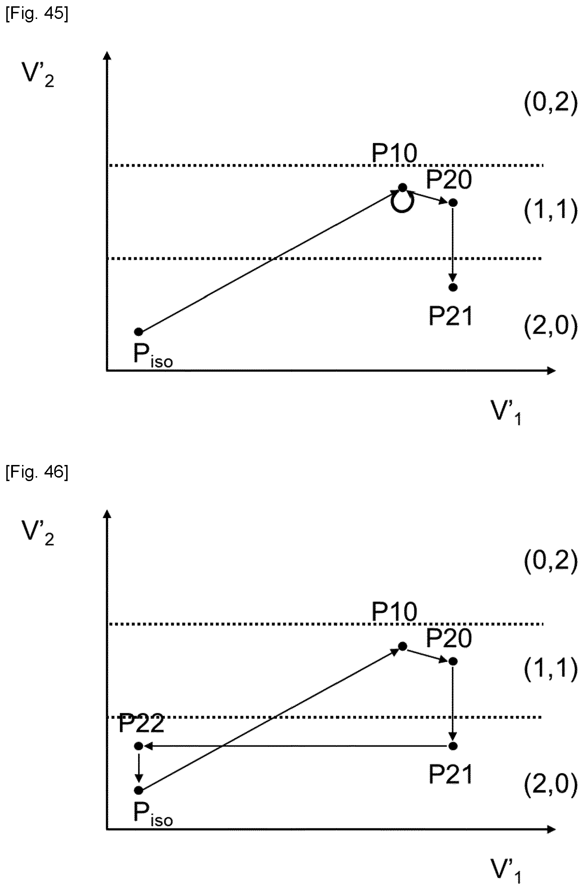

Comme illustré à la [Fig. 45] le procédé comprend ensuite une étape 8E4 de conversion spin/charge à l'aide d'un point de fonctionnement de conversion. Dans l'exemple de la [Fig. 45], cette conversion comprend une sous-étape de modification, à partir du point de fonctionnement initial P10, du point de fonctionnement de sorte à atteindre un point de fonctionnement P20 ayant une valeur du paramètre Γ_{QD} égale à la valeur du paramètre Γ_{QD} du point de fonctionnement de conversion P21, la modification se faisant de manière non-adiabatique (par rapport à l'écart en énergie au niveau du croisement évité entre l'état de spin singulet S et l'état de spin triplet T+). Elle comprend ensuite une sous-étape de modification, à partir du point de fonctionnement P20, du paramètre *ε* de sorte à atteindre le point de fonctionnement de conversion P21, la modification du paramètre *ε* se faisant de manière adiabatique comparativement au paramètre Γ_{QD}.

Le point de fonctionnement de conversion est un point de fonctionnement de conversion connue, par exemple déterminé à l'aide d'un procédé 400 ou tout autre procédé.

Le point de fonctionnement de conversion est un point de fonctionnement de conversion optimal et le procédé 800 comprend donc au préalable, une étape de détermination d'un point de fonctionnement de conversion optimal à l'aide d'un procédé 400. Bien entendu, il est également possible de déterminer un tel point de fonctionnement à l'aide d'autres méthodes.

### Détermination de l'état de charge

Comme illustré à la [Fig. 46], le procédé 800 comprend également une étape 8E5 de détermination de l'état de charge à l'aide du point de fonctionnement de lecture Pᵢₛₒ dans le régime totalement isolé dans lequel, pour une durée de référence, aucun échange de particules chargées PC n'est possible entre les boites quantiques QD1,QD2 du couple CP de boites quantiques QD. Cette étape 8E5 ayant été précédée d'une étape 8E4 de conversion, la mesure de l'état de charge permet de déterminer l'état de spin des particules chargées.

### Caractérisation d'une pluralité de points de fonctionnement

Les étapes précédentes sont répétées pour une pluralité de point de fonctionnement P10 à caractériser et une pluralité de fois pour chacun de ces points de fonctionnement de sorte à déterminer, pour chacun de ces points de fonctionnement, la probabilité de mesurer un état singulet S.

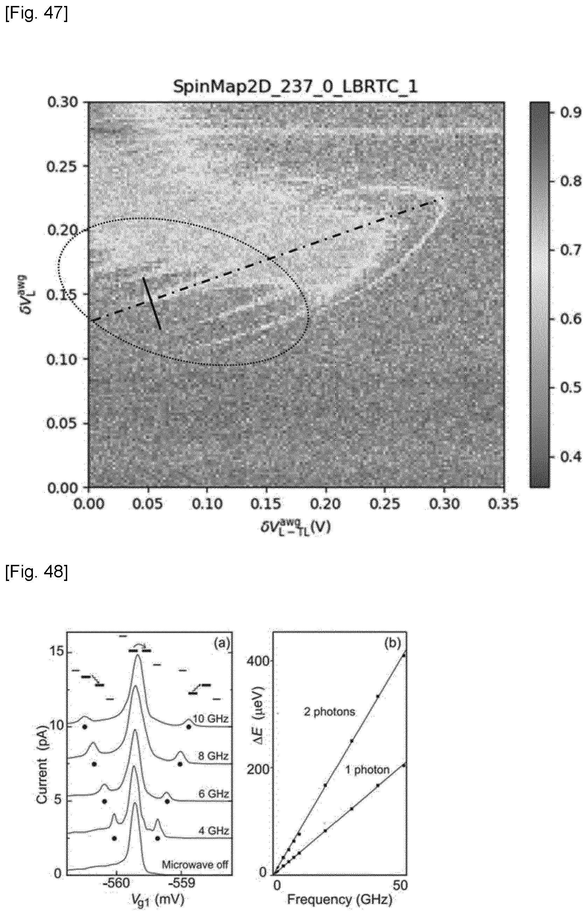

La cartographie ainsi obtenue est illustrée à la [Fig. 47] (sur cette figure, les cross-talk non pas été compensé). Il est possible d'identifier sur cette cartographie la ligne de croisement de l'état de spin singulet S et de l'état de spin triplet T+.

Pour cela, le procédé comprend également une étape (8E6) d'identification de la ligne de croisement de l'état de spin singulet S et de l'état de spin triplet T+.

### Caractérisation de la ligne de croisement

Les étapes précédentes (8E1-8E5) étant répétées pour une pluralité de points de fonctionnement (P10) situés sur une ligne perpendiculaire (c'est-à-dire à couplage tunnel constant) à la ligne de croisement et pour lequel la différence de potentiel énergie entre les deux boites quantiques du couple de boites quantique est nulle et passant par ladite ligne de croisement, et pour une pluralité de champ magnétique de sorte à caractériser l'évolution de la position du croisement en fonction du champ magnétique.

### Détermination du facteur de conversion

Le procédé 800 comprend enfin une étape 8E7 de détermination, à partir de cette évolution, du facteur de conversion entre la tension appliquée aux grilles du système et le couplage tunnel Γ*_{QD}* entre les deux boites quantiques QD1,QD2 du couple CP de boites quantiques QD.

### Procédé de détermination du facteur de conversion entre la tension appliquée aux grilles du système et la différence de potentiels entre les deux boites quantiques

Lors de l'utilisation d'un système SYS il peut être intéressant de déterminer le facteur de conversion permettant de connaître, à partir de la tension de grille appliquée les grilles la différence de potentiel énergie *ε* entre les deux boites quantiques QD.

Pour cela, un huitième aspect de l'invention illustré à la [Fig. 42] concerne un procédé 900 de détermination du facteur de conversion entre la tension appliquée aux grilles du système et la différence de potentiel entre les deux boites quantiques comprenant deux particules chargées, les deux particules chargées PC adoptant soit un état de spin « ud », soit un état de spin « du », soit un état de spin singulet S dans un état fondamental ou une pluralité d'états excités soit un état de spin triplet T0 ou un étape de spin triplet T+/T-.

### Initialisation du système

Comme illustré à la [Fig. 43], le procédé 900 comprend une étape 9E1 d'initialisation du système dans un point de fonctionnement de lecture associé au régime totalement isolé et à l'état de charge (2,0) et dans un état de spin singulet S.

La position du point de fonctionnement de lecture Pᵢₛₒ est connue.

La position du point de fonctionnement de lecture Pᵢₛₒ n'est pas connue et le procédé selon l'invention comprend au préalable une étape de détermination d'un point de fonctionnement dans le régime totalement isolé à l'aide d'un procédé 100 selon l'invention.

L'initialisation du système dans l'état de spin singulet est réalisée à l'aide d'un point de fonctionnement de chargement associé à l'état singulet déterminé à l'aide d'un procédé 200 selon l'invention et le procédé comprend donc, au préalable, une étape de détermination d'un point de fonctionnement.

### Modification non adiabatique

Le procédé 900 comprend ensuite une étape 9E2 de modification du point de fonctionnement de sorte à atteindre un point de fonctionnement P10 à caractériser, ladite modification étant effectuée de manière non adiabatique (par rapport à l'écart en énergie au niveau du croisement évité entre l'état de spin T0 et l'état de spin T0 ou l'état de spin T+) en fonction du couplage tunnel Γ_{QD} entre les deux boites quantiques au point de fonctionnement P10 à caractériser.

Cette modification non-adiabatique va avoir pour conséquence, lorsque le couplage tunnel est fort (c'est-à-dire un couplage tunnel très grand devant le régime complètement isolé), d'induire une oscillation cohérente de l'état de spin entre l'état de spin singulet S et l'état de spin triplet T0 ou l'état de spin triplet T+.

A faible couplage tunnel (c'est-à-dire une couplage tunnel proche du régime totalement isolé), cette modification va induire un excès de triplet par un processus combinant :
- un processus tunnel entre l'état singulet S de l'état de charge (2,0) dans l'état fondamental vers les états singulet S de l'état de charge (1,1) dans des états excités ; et
- un processus de relaxation vers les états de spin « ud » et « du » de l'état fondamental de l'état de charge (1,1).

De préférence, le point de fonctionnement à caractérisé est associé à l'état de charge (1,1), l'exploration des points de fonctionnement associé à l'état de charge (2,0) ou (0,2) ne présentant en général que peu d'intérêt.

### Attente au point de fonctionnement à caractériser.

Comme illustré à la [Fig. 44], le procédé comprend ensuite une étape 9E3 d'attente, sous excitation micro-onde (c'est-à-dire qu'une onde micro-onde à une fréquence donnée est appliquée au système durant ce temps d'attente), au point de fonctionnement à caractériser durant une durée choisie aléatoirement dans l'intervalle $\left[\frac{1}{{f}_{Rabi}^{max}}, \frac{1}{{f}_{Rabi}^{min}}\right]$ de sorte à laisser librement l'état de spin osciller de manière cohérente. Pour rappel, ${f}_{Rabi}^{max}$ est la vitesse maximale d'oscillation entre l'état de spin singulet S et l'état de spin triplet T0 et/ou l'état de spin triplet T+ et ${f}_{Rabi}^{min}$ est la vitesse minimale d'oscillation entre l'état de spin singulet S et l'état de spin triplet T0 et/ou l'état de spin triplet T+.

Autrement dit, pour établir l'intervalle de temps, on prendra pour référence soit les états de spin singulet S et triplet T0, soit les états de spin singulet S et triplet T+, soit, pour chaque détermination de l'intervalle de temps, l'un des couples ST0 ou ST+ sera choisi aléatoirement comme référence.

### Conversion spin-charge

Comme illustré à la [Fig. 45] Le procédé comprend ensuite une étape 9E4 de conversion spin/charge à l'aide d'un point de fonctionnement de conversion. Dans l'exemple de la [Fig. 45], cette conversion comprend une sous-étape de modification, à partir du point de fonctionnement initial P10, du point de fonctionnement de sorte à atteindre un point de fonctionnement P20 ayant une valeur du paramètre Γ_{QD} égale à la valeur du paramètre Γ_{QD} du point de fonctionnement de conversion P21, la modification se faisant de manière non-adiabatique (par rapport à l'écart en énergie au niveau du croisement évité entre l'état de spin T0 et l'état de spin T+). Elle comprend ensuite une sous-étape de modification, à partir du point de fonctionnement P20, du paramètre *ε* de sorte à atteindre le point de fonctionnent de conversion P21, la modification du paramètre *ε* se faisant de manière adiabatique comparativement au paramètre Γ_{QD}.

Le point de fonctionnement de conversion est un point de fonctionnement de conversion connue, par exemple déterminé à l'aide d'un procédé 400 selon l'invention ou tout autre procédé.

Le point de fonctionnement de conversion est un point de fonctionnement de conversion optimal et le procédé 900 comprend donc au préalable, une étape de détermination d'un point de fonctionnement de conversion optimal à l'aide d'un procédé 400 selon l'invention. Bien entendu, il est également possible de déterminer un tel point de fonctionnement à l'aide d'autres méthodes.

### Détermination de l'état de charge

Comme illustré à la [Fig. 46], le procédé 900 comprend également une étape 9E5 de détermination de l'état de charge à l'aide du point de fonctionnement de lecture Pᵢₛₒ dans le régime totalement isolé dans lequel, pour une durée de référence, aucun échange de particules chargées PC n'est possible entre les boites quantiques QD1,QD2 du couple CP de boites quantiques QD. Cette étape 9E5 ayant été précédée d'une étape 9E4 de conversion, la mesure de l'état de charge permet de déterminer l'état de spin des particules chargées.

### Caractérisation d'une pluralité de points de fonctionnement

Les étapes précédentes sont répétées pour une pluralité de point de fonctionnement P10 à caractériser et une pluralité de fois pour chacun de ces points de fonctionnement de sorte à déterminer, pour chacun de ces points de fonctionnement, la probabilité de mesurer un état singulet S.

La cartographie ainsi obtenue est illustrée à la [Fig. 47] (sur cette figure, les cross-talk non pas été compensé). Il est possible d'identifier sur cette cartographie des lignes correspondant aux états excités orbitaux selon le processus décrit précédemment pour le cas faible couplage tunnel dans la zone entourée, l'une de ces excitations étant mises en évidence à l'aide d'une ligne en trait interrompu sur la [Fig. 47].

Pour cela le procédé comprend une étape 9E6 d'identification d'au moins une ligne des états excités orbitaux.

### Caractérisation de la ligne d'excitation

Les étapes précédentes étant répétées pour une pluralité de points de fonctionnement situés sur une ligne perpendiculaire (c'est-à-dire à couplage tunnel constant) à la ligne d'états excités orbitaux et passant par ladite ligne de sorte à caractériser l'excitation due aux micro-ondes. De plus, la caractérisation de l'excitation est répétée pour une pluralité de fréquences de sorte à mesurer l'évolution de l'excitation en fonction de la fréquence micro-onde appliquée au système lors de l'étape 9E3 d'attente.

### Détermination du facteur de conversion

Il est ensuite possible de déterminer, à partir de cette évolution, le facteur de conversion entre la tension appliquée aux grilles du système et la différence de potentiel *ε* entre les deux boites quantiques QD. En effet, comme illustré à la [Fig. 48], l'application d'une fréquence micro-onde va générer, en plus du pic central associé aux états excités, deux pics secondaires situés de part et d'autre du pic principal, l'écart entre le pic principal étant fonction de la fréquence appliquée. Il est ensuite possible d'extraire de l'évolution de cet écart le facteur de conversion recherché.

Pour cela, le procédé 900 comprend enfin une étape 9E7 de détermination, à partir de cette évolution, du facteur de conversion entre la tension appliquée aux grilles du système et la différence de potentiel *ε* entre les deux boites quantiques QD1,QD2 du couple CP de boites quantiques QD. Une fois ce facteur de conversion connue, il est ensuite possible d'en déduire les paramètres du système que sont l'énergie de charge du système et les énergies associées aux états excités orbitaux.

## Revendications

1. Procédé (900) de détermination du facteur de conversion entre une tension appliquée aux grilles d'un système (SYS) et la différence de potentiel entre une première boite quantique (QD1) et une deuxième boite quantique (QD2) d'un couple de boites quantiques (QD), le système (SYS) comprenant un couple (CP) de boites quantiques (QD) contenant deux particules chargées (PC) et comportant une première boite quantique (QD1) et une deuxième boite quantique (QD2), un couplage tunnel existant entre la première boite quantique (QD1) et la deuxième boite quantique (QD2), la différence de potentiel entre la première boite quantique (QD1) et de la deuxième boite quantique (QD2) étant modulée à l'aide d'une pluralité de grilles, un jeu de tensions appliqué sur lesdites grilles de la pluralité de grilles définissant un point de fonctionnement du système (SYS), le couple (CP) de boites quantiques (QD) étant dans un état de charge parmi l'état de charge {2,0}, l'état de charge {1,1} et l'état de charge {0,2}, et les deux particules chargées (PC) adoptant soit un état de spin « ud », soit un état de spin « du » avec u représentant un état de spin « up » et le d représentant un état de spin « down », soit un état de spin singulet S dans un état fondamental ou une pluralité d'états excités soit un état de spin triplet T0 ou un étape de spin triplet T+/T-, le procédé comprenant :
- une étape (9E1) d'initialisation du système dans un point de fonctionnement de lecture associé au régime totalement isolé et à l'état de charge {2,0} et l'état de spin singulet S ;
- une étape (9E2) de modification du point de fonctionnement de sorte à atteindre un point de fonctionnement (P10) à caractériser, ladite modification étant effectuée de manière non adiabatique de sorte à entrainer une oscillation cohérente de l'état de spin en fonction du couplage tunnel entre les deux boites quantiques (QD) au point de fonctionnement (P10) à caractériser ;
- une étape (9E3) d'attente, sous une excitation micro-onde, au point de fonctionnement à caractériser durant une durée choisie aléatoirement dans l'intervalle $\left[\frac{1}{{f}_{Rabi}^{max}}, \frac{1}{{f}_{Rabi}^{min}}\right]$ de sorte à laisser librement l'état de spin osciller de manière cohérente où ${f}_{Rabi}^{max}$ est la vitesse maximale d'oscillation entre l'état de spin singulet S et l'état de spin triplet T0 et/ou l'état de spin triplet T+/T- et ${f}_{Rabi}^{min}$ est la vitesse minimale d'oscillation entre l'état de spin singulet S et l'état de spin triplet T0 et/ou l'état de spin triplet T+/T- ;
- une étape (9E4) de conversion spin/charge à l'aide d'un point de fonctionnement de conversion ;
- une étape (9E5) de détermination de l'état de charge à l'aide du point de fonctionnement de lecture (Piso) dans une régime totalement isolé dans lequel, pour une durée de référence, aucun échange de particules chargées (PC) n'est possible entre les boites quantiques (QD1,QD2) du couple (CP) de boites quantiques (QD) ;
ces étapes (9E1-9E5) étant répétées pour une pluralité de point de fonctionnement (P10) à caractériser et une pluralité de fois pour chacun de ces points de fonctionnement de sorte à déterminer, pour chacun de ces points de fonctionnement, la probabilité de mesurer un état singulet S ; le procédé comprenant ensuite :
- une étape (9E6) d'identification d'au moins une ligne d'états excités dans un diagramme de stabilité du couple de boites quantique ;
les étapes précédentes (9E1-9E5) étant répétées pour une pluralité de points de fonctionnement (P10) situés sur une même ligne perpendiculaire à la ligne d'états excités et passant par ladite ligne d'états excités et pour une pluralité de fréquences de l'excitation micro-onde de sorte à caractériser la ligne des états excités due à l'excitation micro-onde et son évolution en fonction de la fréquence de l'excitation micro-onde appliquée au système ; le procédé comprenant ensuite :
- une étape (9E7) de détermination, à partir de cette évolution, du facteur de conversion entre la tension appliquée aux grilles du système et la différence de potentiel *ε* entre les deux boites quantiques (QD1,QD2) du couple (CP) de boites quantiques (QD).

2. Procédé (900) selon la revendication précédente dans lequel l'énergie de charge est un paramètre du système, le procédé comprenant, après l'étape étape (9E7) de détermination du facteur de conversion, une étape de détermination, à partir de ce facteur de conversion, de l'énergie de charge du système et des énergies associées aux états excités.

3. Procédé (800) de détermination du facteur de conversion entre une tension appliquée aux grilles d'un système (SYS) et le couplage tunnel Γ*_{QD}* entre les deux boites quantiques (QD1,QD2) du couple (CP) de boites quantiques (QD), le système (SYS) comprenant un couple (CP) de boites quantiques (QD) contenant deux particules chargées (PC) et comportant une première boite quantique (QD1) et une deuxième boite quantique (QD2), et le couplage tunnel Γ*_{QD}* entre les deux boites quantiques (QD1,QD2) du couple (CP) de boites quantiques (QD) étant modulée à l'aide d'une pluralité de grilles, un jeu de tensions appliqués sur lesdites grilles de la pluralité de grilles définissant un point de fonctionnement du système (SYS), le couple (CP) de boites quantiques (QD) étant dans un état de charge parmi un premier état de charge {2,0} dans lequel les deux particules chargées (PC) sont dans la première boite quantique (QD1), un deuxième état de charge {1,1} dans lequel une particule chargée est dans chaque boite quantique (QD1,QD2), et un troisième état de charge {0,2} dans lequel les deux particules chargées (PC) sont dans la deuxième boite quantique (QD2), et les deux particules chargées (PC) adoptant soit un état de spin singulet S soit un état de spin triplet T+/T-, le procédé comprenant :
- une étape (8E1) d'initialisation du système dans un point de fonctionnement de lecture associé au régime totalement isolé, au premier état de charge {2,0} et à l'état de spin singulet S ;
- une étape (8E2) de modification du point de fonctionnement de sorte à atteindre un point de fonctionnement (P10) à caractériser, ladite modification étant effectuée de manière non adiabatique de sorte à entrainer une oscillation cohérente de l'état de spin singulet S à l'état de spin triplet T+/T- ;
- une étape (8E3) d'attente au point de fonctionnement à caractériser durant une durée choisie aléatoirement dans l'intervalle $\left[\frac{1}{{f}_{Rabi}^{max}}, \frac{1}{{f}_{Rabi}^{min}}\right]$ de sorte à laisser librement l'état de spin osciller de manière cohérente où ${f}_{Rabi}^{max}$ est la vitesse maximale d'oscillation entre l'état de spin singulet S et l'état de spin triplet T+/T- et ${f}_{Rabi}^{min}$ est la vitesse minimale d'oscillation entre l'état de spin singulet S et l'état de spin triplet T+/T- ;
- une étape (8E4) de conversion spin/charge à l'aide d'un point de fonctionnement de conversion ;
- une étape (8E5) de détermination de l'état de charge à l'aide du point de fonctionnement de lecture (Piso) dans un régime totalement isolé dans lequel, pour une durée de référence, aucun échange de particules chargées (PC) n'est possible entre les boites quantiques (QD1,QD2) du couple (CP) de boites quantiques (QD) ;
ces étapes (8E1-8E5) étant répétées pour une pluralité de point de fonctionnement (P10) à caractériser et une pluralité de fois pour chacun de ces points de fonctionnement de sorte à déterminer, pour chacun de ces points de fonctionnement, la probabilité de mesurer un état singulet S ; le procédé comprenant ensuite :
- une étape (8E6) d'identification de la ligne de croisement de l'état de spin singulet S et de l'état de spin triplet T+/T- dans un diagramme de stabilité du couple de boites quantiques ;
les étapes précédentes (8E1-8E5) étant répétées pour une pluralité de points de fonctionnement (P10) situés sur une même ligne perpendiculaire à la ligne de croisement et pour lequel la différence de potentiel entre les deux boites quantiques du couple de boites quantique est nulle et passant par ladite ligne de croisement, et pour une pluralité de champs magnétiques de sorte à caractériser l'évolution de la position du croisement en fonction du champ magnétique ; le procédé comprenant ensuite :
- une étape (8E7) de détermination, à partir de cette évolution, du facteur de conversion entre la tension appliquée aux grilles du système et le couplage tunnel Γ*_{QD}* entre les deux boites quantiques (QD1,QD2) du couple (CP) de boites quantiques (QD).

4. Système (SYS) comprenant un premier sous-système (CP/QD1) et un deuxième sous-système (RE/QD2) le premier sous-système (CP/QD1) et/ou le deuxième sous-système (RE) étant susceptible de contenir zéro, une ou plusieurs particules chargées (PC), un couplage tunnel existant entre le premier sous-système (CP/QD1) et le deuxième sous-système (RE,QD2), ledit couplage permettant l'échange d'une ou plusieurs particules chargées (PC) entre le premier sous-système (CP/QD1) et le deuxième sous-système (RE/QD2) et étant modulé par une tension de grille appliquée à une ou plusieurs grilles configurées pour former une barrière de potentiel entre le premier sous-système (CP/QD1) et le deuxième sous-système (RE/QD2), le système comprenant également un moyen de mesure (CS) de l'état de charge du premier sous-système et/ou du deuxième sous-système, le système (SYS) comprenant également des moyens configurés pour exécuter les étapes du procédé selon l'une des revendications précédentes.

5. Programme d'ordinateur comprenant des instructions qui conduisent le système selon la revendication précédente à exécuter les étapes du procédé selon l'une des revendications 1 à 3 lorsque ledit programme est exécuté sur un ordinateur.

6. Support lisible par ordinateur, sur lequel est enregistré le programme d'ordinateur selon la revendication précédente.

## Patentansprüche

1. Verfahren (900) zur Bestimmung des Umwandlungsfaktors zwischen einer an die Gitter eines Systems (SYS) angelegten Spannung und der Potentialdifferenz zwischen einem ersten Quantenpunkt (QD1) und einem zweiten Quantenpunkt (QD2) eines Quantenpunkt-Paares (QD), wobei das System (SYS) ein Paar (CP) von Quantenpunkten (QD) umfasst, das zwei geladene Teilchen (PC) enthält und einen ersten Quantenpunkt (QD1) sowie einen zweiten Quantenpunkt (QD2) aufweist, wobei zwischen dem ersten Quantenpunkt (QD1) und dem zweiten Quantenpunkt (QD2) eine Tunnelkopplung besteht, wobei die Potentialdifferenz zwischen dem ersten Quantenpunkt (QD1) und dem zweiten Quantenpunkt (QD2) mittels einer Vielzahl von Gitterelementen moduliert wird, wobei ein an die Gitterelemente der Vielzahl von Gitterelementen angelegter Spannungssatz einen Betriebspunkt des Systems (SYS) definiert, wobei sich das Quantenpunktpaar (CP) in einem Ladungszustand unter den Ladungszuständen {2,0}, {1,1} und {0,2} befindet und die beiden geladenen Teilchen (PC) entweder einen "ud"-Spin-Zustand annehmen, oder einen "du"-Spin-Zustand, wobei "u" einen "up"-Spin-Zustand und "d" einen "down"-Spin-Zustand darstellt, oder einen Singulett-Spin-Zustand "S" in einem Grundzustand oder einer Vielzahl von angeregten Zuständen, oder einen Triplett-Spin-Zustand T0 oder einen Triplett-Spin-Zustand T+/T-, wobei das Verfahren umfasst:
- einen Schritt (9E1) zum Initialisieren des Systems in einen Lesebetriebspunkt, der dem vollständig isolierten Zustand und dem Ladungszustand {2,0} sowie dem Singulett-Spin-Zustand S zugeordnet ist;
- einen Schritt (9E2) zum Ändern des Betriebspunkts, um einen zu charakterisierenden Betriebspunkt (P10) zu erreichen, wobei die Änderung auf nicht-adiabatische Weise erfolgt, um eine kohärente Schwingung des Spinzustands in Abhängigkeit von der Tunnelkopplung zwischen den beiden Quantenpunkten (QD) am zu charakterisierenden Betriebspunkt (P10) zu bewirken;
- eine Wartephase (9E3), unter Mikrowellenanregung an dem zu charakterisierenden Betriebspunkt während einer zufällig gewählten Dauer im Intervall $\left[\frac{1}{\int \frac{max}{Rabi}}, \frac{1}{\int \frac{min}{Rabi}}\right]$, so dass der Spin-Zustand frei und kohärent oszillieren kann, wobei $\int \frac{max}{Rabi}$ die maximale Oszillationsgeschwindigkeit zwischen dem Singulett-Spin-Zustand S und dem Triplett-Spin-Zustand T0 und/oder dem Triplett-Spin-Zustand T+/T- und $\int \frac{min}{Rabi}$ die minimale Oszillationsgeschwindigkeit zwischen dem Singulett-Spin-Zustand S und dem Triplett-Spin-Zustand T0 und/oder dem Triplett-Spin-Zustand T+/T- ist;
- einen Schritt (9E4) der Spin-Ladungs-Umwandlung unter Verwendung eines Umwandlungs-Betriebspunkts;
- einen Schritt (9E5) zur Bestimmung des Ladungszustands unter Verwendung des Lese-Betriebspunkts (Piso) in einem vollständig isolierten Zustand, in dem für eine Referenzdauer kein Austausch geladener Teilchen (PC) zwischen den Quantenpunkten (QD1, QD2) des Paares (CP) von Quantenpunkten (QD) möglich ist;
wobei diese Schritte (9E1-9E5) für eine Vielzahl von zu charakterisierenden Betriebspunkten (P10) und für jeden dieser Betriebspunkte mehrfach wiederholt werden, um für jeden dieser Betriebspunkte die Wahrscheinlichkeit der Messung eines Singulettzustands S zu bestimmen; wobei das Verfahren anschließend umfasst:
- einen Schritt (9E6) zur Identifizierung mindestens einer Linie angeregter Zustände in einem Stabilitätsdiagramm des Quantenpunkt-Paares;
wobei die vorangegangenen Schritte (9E1-9E5) für eine Vielzahl von Betriebspunkten (P10), die auf derselben Linie liegen, die senkrecht zur Linie der angeregten Zustände verläuft und durch diese Linie der angeregten Zustände geht, sowie für eine Vielzahl von Frequenzen der Mikrowellenanregung wiederholt werden, um die durch die Mikrowellenanregung bedingte Linie der angeregten Zustände und deren Entwicklung in Abhängigkeit von der Frequenz der auf das System angewendeten Mikrowellenanregung zu charakterisieren; wobei das Verfahren anschließend umfasst:
- einen Schritt (9E7) zur Bestimmung des Umwandlungsfaktors zwischen der an die Gitter des Systems angelegten Spannung und der Potentialdifferenz *ε* zwischen den beiden Quantenpunkten (QD1, QD2) des Quantenpunktpaares (CP) (QD) auf der Grundlage dieser Entwicklung.

2. Verfahren (900) gemäß dem vorstehenden Anspruch, bei dem die Ladungsenergie ein Systemparameter ist, wobei das Verfahren nach dem Schritt (9E7) zur Bestimmung des Umwandlungsfaktors einen Schritt umfasst, bei dem ausgehend von diesem Umwandlungsfaktor die Ladungsenergie des Systems und die mit den angeregten Zuständen verbundenen Energien bestimmt werden.

3. Verfahren (800) zur Bestimmung des Umwandlungsfaktors zwischen einer an die Gitter eines Systems (SYS) angelegten Spannung und der Γ*_{QD}-*Tunnelkopplung zwischen den beiden Quantenpunkten (QD1, QD2) des Paares (CP) von Quantenpunkten (QD), wobei das System (SYS) ein Quantenpunktpaar (CP) umfasst, das zwei geladene Teilchen (PC) enthält und einen ersten Quantenpunkt (QD1) sowie einen zweiten Quantenpunkt (QD2) aufweist, und wobei die Γ*_{QD}*-Tunnelkopplung zwischen den beiden Quantenpunkten (QD1, QD2) des Paares (CP) von Quantenpunkten (QD) mittels einer Vielzahl von Gittern moduliert wird, wobei ein Satz von Spannungen, die an diese Gitter der Vielzahl von Gittern angelegt werden, einen Betriebspunkt des Systems (SYS) definiert, wobei sich das Quantenpunkt-Paar (CP) in einem Ladungszustand befindet, der aus einem ersten Ladungszustand {2,0}, in dem sich beide geladenen Teilchen (PC) im ersten Quantenpunkt (QD1) befinden, einem zweiten Ladungszustand {1,1}, in dem sich jeweils ein geladenes Teilchen in jedem Quantenpunkt (QD1, QD2) befindet, und einem dritten Ladungszustand {0,2}, in dem sich beide geladenen Teilchen (PC) im zweiten Quantenpunkt (QD2) befinden, besteht, und wobei beide geladenen Teilchen (PC) entweder einen Singulett-Spin-Zustand S oder einen Triplett-Spin-Zustand T+/T-annehmen, wobei das Verfahren umfasst:
- einen Schritt (8E1) zum Initialisieren des Systems in einen Lesebetriebspunkt, der dem vollständig isolierten Zustand, dem ersten Ladungszustand {2,0} und dem Singulett-Spin-Zustand S zugeordnet ist;
- einen Schritt (8E2) zur Änderung des Betriebspunkts, um einen zu charakterisierenden Betriebspunkt (P10) zu erreichen, wobei die Änderung auf nicht-adiabatische Weise erfolgt, um eine kohärente Oszillation vom Singulett-Spin-Zustand S zum Triplett-Spin-Zustand T+/T- zu bewirken;
- einen Warteschritt (8E3) am zu charakterisierenden Betriebspunkt während einer zufällig gewählten Dauer im Intervall $\left[\frac{1}{\int \frac{max}{Rabi}}, \frac{1}{\int \frac{min}{Rabi}}\right]$, um den Spinzustand frei und kohärent oszillieren zu lassen, wobei $\int \frac{max}{Rabi}$ die maximale Oszillationsgeschwindigkeit zwischen dem Singulett-Spinzustand S und dem Triplett-Spinzustand T+/T- und $\int \frac{min}{Rabi}$ die minimale Oszillationsgeschwindigkeit zwischen dem Singulett-Spin-Zustand S und dem Triplett-Spin-Zustand T+/T- ist;
- einen Schritt (8E4) zur Spin-Ladungs-Umwandlung unter Verwendung eines Umwandlungs-Betriebspunkts;
- einen Schritt (8E5) zur Bestimmung des Ladungszustands unter Verwendung des Lesebetriebspunkts (Piso) in einem vollständig isolierten Zustand, in dem für eine Referenzdauer kein Austausch geladener Teilchen (PC) zwischen den Quantenpunkten (QD1, QD2) des Quantenpunktpaares (CP) möglich ist;
wobei diese Schritte (8E1-8E5) für eine Vielzahl von zu charakterisierenden Betriebspunkten (P10) und für jeden dieser Betriebspunkte mehrfach wiederholt werden, um für jeden dieser Betriebspunkte die Wahrscheinlichkeit der Messung eines Singulettzustands S zu bestimmen; wobei das Verfahren anschließend umfasst:
- einen Schritt (8E6) zur Identifizierung der Kreuzungslinie des Singulett-Spin-Zustands S und des Triplett-Spin-Zustands T+/T- in einem Stabilitätsdiagramm des Quantenpunktpaares;
wobei die vorangegangenen Schritte (8E1-8E5) für eine Vielzahl von Betriebspunkten (P10) wiederholt werden, die auf derselben zur Kreuzungslinie senkrechten Linie liegen und für die die Potentialdifferenz zwischen den beiden Quantenpunkten des Quantenpunktpaares null ist und die durch diese Kreuzungslinie verläuft, sowie für eine Vielzahl von Magnetfeldern, um die Entwicklung der Kreuzungsposition in Abhängigkeit vom Magnetfeld zu charakterisieren; wobei das Verfahren anschließend umfasst:
- einen Schritt (8E7) zur Bestimmung des Umwandlungsfaktors zwischen der an die Gitter des Systems angelegten Spannung und der Γ*_{QD}-*Tunnelkopplung zwischen den beiden Quantenpunkten (QD1, QD2) des Quantenpunktpaares (CP) (QD) auf der Grundlage dieser Entwicklung.

4. System (SYS), das ein erstes Teilsystem (CP/QD1) und ein zweites Teilsystem (RE/QD2) umfasst, wobei das erste Teilsystem (CP/QD1) und/oder das zweite Teilsystem (RE) null, ein oder mehrere geladene Teilchen (PC) enthalten kann, wobei zwischen dem ersten Teilsystem (CP/QD1) und dem zweiten Teilsystem (RE, QD2) eine Tunnelkopplung besteht, die den Austausch eines oder mehrerer geladener Teilchen (PC) zwischen dem ersten Teilsystem (CP/QD1) und dem zweiten Teilsystem (RE/QD2) ermöglicht und durch eine an ein oder mehrere Gitter angelegte Gatespannung moduliert wird, die so ausgelegt sind, dass sie eine Potentialbarriere zwischen dem ersten Teilsystem (CP/QD1) und dem zweiten Teilsystem (RE/QD2) bilden, wobei das System außerdem eine Einrichtung (CS) zum Messen des Ladungszustands des ersten Teilsystems und/oder des zweiten Teilsystems umfasst, wobei das System (SYS) außerdem Einrichtungen umfasst, die so ausgelegt sind, dass sie die Verfahrensschritte gemäß einem der vorstehenden Ansprüche ausführen.

5. Computerprogramm, das Befehle umfasst, die das System gemäß dem vorstehenden Anspruch veranlassen, die Verfahrensschritte gemäß einem der Ansprüche 1 bis 3 auszuführen, wenn das Programm auf einem Computer ausgeführt wird.

6. Computerlesbares Medium, auf dem das Computerprogramm gemäß dem vorstehenden Anspruch gespeichert ist.

## Claims

1. A method (900) for determining the conversion factor between a voltage applied to the gates of a system (SYS) and the potential difference between a first quantum dot (QD1) and a second quantum dot (QD2) of a pair of quantum dots (QD), the system (SYS) comprising a pair (CP) of quantum dots (QD) containing two charged particles (PC) and including a first quantum dot (QD1) and a second quantum dot (QD2), a tunnel coupling existing between the first quantum dot (QD1) and the second quantum dot (QD2), the potential difference between the first quantum dot (QD1) and the second quantum dot (QD2) being modulated using a plurality of gates, a set of voltages applied to said gates of the plurality of gates defining an operating point of the system (SYS), the pair (CP) of quantum dots (QD) being in one charge state from the charge state {2,0}, the charge state {1,1} and the charge state {0,2}, and both charged particles (PC) adopting either a "ud" spin state or a "du" spin state with u representing an "up" spin state and the d representing a "down" spin state, or a singlet spin state S in a ground state or a plurality of excited states or a triplet spin state T0 or a triplet spin state T+/T-, the method comprising:
- a step (9E1) of initialising the system in a reading operating point associated with the fully isolated regime and the charge state {2,0} and the singlet spin state S ;
- a step (9E2) of modifying the operating point so as to reach an operating point (P10) to be characterised, said modifying being non-adiabatically carried out so as to cause a coherent oscillation of the spin state as a function of the tunnel coupling between both quantum dots (QD) at the operating point (P10) to be characterised;
- a step (9E3) of waiting, under microwave excitation, at the operating point to be characterised for a randomly chosen duration in the interval $\left[\frac{1}{{f}_{Rabi}^{max}}, \frac{1}{{f}_{Rabi}^{min}}\right]$ so as to let the spin state freely oscillate in a coherent manner, where ${f}_{Rabi}^{max}$ is the maximum oscillation speed between the singlet spin state S and the triplet spin state T0 and/or the triplet spin state T+/T- and ${f}_{Rabi}^{min}$ is the minimum oscillation speed between the singlet spin state S and the triplet spin state T0 and/or the triplet spin state T+/T- ;
- a spin/charge conversion step (9E4) using a conversion operating point; and
- a step (9E5) of determining the charge state using the reading operating point (Piso) in a fully isolated regime in which, for a reference duration, no exchange of charged particles (PC) is possible between the quantum dots (QD1, QD2) of the pair (CP) of quantum dots (QD);
these steps (9E1-9E5) being repeated for a plurality of operating points (P10) to be characterised and a plurality of times for each of these operating points so as to determine, for each of these operating points, the probability of measuring a singlet state S; the method then comprising:
- a step (9E6) of identifying at least one line of excited states in a stability diagram of the pair of quantum dots;
the preceding steps (9E1-9E5) being repeated for a plurality of operating points (P10) located on a same line perpendicular to the line of excited states and passing through said line of excited states and for a plurality of frequencies of the microwave excitation so as to characterise the line of excited states due to the microwave excitation and its course as a function of the frequency of the microwave excitation applied to the system; the method then comprising:
- a step (9E7) of determining, from this course, the conversion factor between the voltage applied to the gates of the system and the potential difference ε between both quantum dots (QD1, QD2) of the pair (CP) of quantum dots (QD).

2. The method (900) according to the preceding claim, wherein the charge energy is a parameter of the system, the method comprising, after the step (9E7) of determining the conversion factor, a step of determining, from this conversion factor, the charge energy of the system and energies associated with the excited states.

3. A method (800) for determining the conversion factor between a voltage applied to the gates of a system (SYS) and the tunnel coupling Γ*_{QD}* between both quantum dots (QD1, QD2) of the pair (CP) of quantum dots (QD), the system (SYS) comprising a pair (CP) of quantum dots (QD) containing two charged particles (PC) and including a first quantum dot (QD1) and a second quantum dot (QD2), and the tunnel coupling Γ*_{QD}* between both quantum dots (QD1,QD2) of the pair (CP) of quantum dots (QD) being modulated using a plurality of gates, a set of voltages applied to said gates of the plurality of gates defining an operating point of the system (SYS), the pair (CP) of quantum dots (QD) being in one charge state from a first charge state {2,0} in which both charged particles (PC) are in the first quantum dot (QD1), a second charge state {1,1} in which one charged particle is in each quantum dot (QD1,QD2), and a third charge state {0,2} in which both charged particles (PC) are in the second quantum dot (QD2), and both charged particles (PC) adopting either a singlet spin state S or a triplet spin state T+/T-, the method comprising:
- a step (8E1) of initialising the system in a reading operating point associated with the fully isolated regime, the first charge state {2,0} and the singlet spin state S ;
- a step (8E2) of modifying the operating point so as to reach an operating point (P10) to be characterised, said modifying being non-adiabatically carried out so as to cause a coherent oscillation from the singlet spin state S to the triplet spin state T+/T- ;
- a step (8E3) of waiting at the operating point to be characterised for a randomly selected duration in the range $\left[\frac{1}{{f}_{Rabi}^{max}}, \frac{1}{{f}_{Rabi}^{min}}\right]$so as to let the spin state freely oscillate in a coherent manner, where ${f}_{Rabi}^{max}$ is the maximum oscillation speed between the singlet spin state S and the triplet spin state T+/T- and ${f}_{Rabi}^{min}$ is the minimum oscillation speed between the singlet spin state S and the triplet spin state T+/T- ;
- a spin/charge conversion step (8E4) using a conversion operating point;
- a step (8E5) of determining the charge state using the reading operating point (Piso) in a fully isolated regime in which, for a reference duration, no exchange of charged particles (PC) is possible between the quantum dots (QD1, QD2) of the pair (CP) of quantum dots (QD);
these steps (8E1-8E5) being repeated for a plurality of operating points (P10) to be characterised and a plurality of times for each of these operating points so as to determine, for each of these operating points, the probability of measuring a singlet state S; the method then comprising:
- a step (8E6) of identifying the crossing line of the singlet spin state S and the triplet spin state T+/T- in a stability diagram of the pair of quantum dots;
the preceding steps (8E1-8E5) being repeated for a plurality of operating points (P10) located on a same line perpendicular to the crossing line and for which the potential difference between both quantum dots of the pair of quantum dots is zero and passing through said crossing line, and for a plurality of magnetic fields so as to characterise the course of the crossing position as a function of the magnetic field; the method then comprising:
- a step (8E7) of determining, from this course, the conversion factor between the voltage applied to the gates of the system and the tunnel coupling Γ*_{QD}* between both quantum dots (QD1,QD2) of the pair (CP) of quantum dots (QD).

4. A system (SYS) comprising a first subsystem (CP/QD1) and a second subsystem (RE/QD2), the first subsystem (CP/QD1) and/or the second subsystem (RE) being likely to contain zero, one or more charged particles (PC), a tunnel coupling existing between the first subsystem (CP/QD1) and the second subsystem (RE,QD2), said coupling allowing exchange of one or more charged particles (PC) between the first subsystem (CP/QD1) and the second subsystem (RE/QD2) and being modulated by a gate voltage applied to one or more gates configured to form a potential barrier between the first subsystem (CP/QD1) and the second subsystem (RE/QD2), the system also comprising a means for measuring (CS) the charge state of the first subsystem and/or the second subsystem, the system (SYS) also comprising means configured to execute the steps of the method according to any of the preceding claims.

5. A computer program comprising instructions which cause the system according to the preceding claim to execute the steps of the method according to any of claims 1 to 3 when said program is executed on a computer.

6. A computer-readable medium on which the computer program according to the preceding claim is recorded.
